(19)

Europäisches
Patentamt
European
Patent Office
Office européen
des brevets

(11) **EP 4 394 493 A1**

(12) **EUROPEAN PATENT APPLICATION**
published in accordance with Art. 153(4) EPC

(43) Date of publication:
**03.07.2024 Bulletin 2024/27**

(21) Application number: **21957142.9**

(22) Date of filing: **17.09.2021**

(51) International Patent Classification (IPC):
**G02F 1/1345** *(2006.01)*　　　**G09F 9/00** *(2006.01)*
**H05K 1/18** *(2006.01)*

(52) Cooperative Patent Classification (CPC):
**G02F 1/1345; G09F 9/00; H05K 1/18**

(86) International application number:
**PCT/CN2021/119177**

(87) International publication number:
**WO 2023/039861 (23.03.2023 Gazette 2023/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **BOE Technology Group Co., Ltd.
Chaoyang District,
Beijing 100015 (CN)**
• **Chengdu BOE Optoelectronics Technology Co.,
Ltd.
Chengdu, Sichuan 611731 (CN)**

(72) Inventors:
• **ZHANG, Qijun
Beijing 100176 (CN)**

• **LI, Tianma
Beijing 100176 (CN)**
• **LI, Liang
Beijing 100176 (CN)**
• **JI, Bin
Beijing 100176 (CN)**
• **JI, Xuelian
Beijing 100176 (CN)**
• **WANG, Guohui
Beijing 100176 (CN)**
• **DING, Xuefeng
Beijing 100176 (CN)**
• **WANG, Dake
Beijing 100176 (CN)**

(74) Representative: **Hoffmann Eitle
Patent- und Rechtsanwälte PartmbB
Arabellastraße 30
81925 München (DE)**

(54) **CIRCUIT BOARD ASSEMBLY, DISPLAY MODULE AND MANUFACTURING METHOD THEREFOR, AND DISPLAY DEVICE**

(57) A circuit board assembly (100), comprising a first circuit board (1) and at least one second circuit board (2). The first circuit board (1) comprises at least one first binding assembly (11), and the first binding assembly (11) comprises a plurality of first conductive blocks (111) sequentially arranged at intervals in a first direction. The at least one second circuit board (2) comprises at least one second binding assembly (21), and the second binding assembly (21) comprises a plurality of second conductive blocks (211) sequentially arranged at intervals; the plurality of second conductive blocks (211) in one second binding assembly (21) are bound and connected to the plurality of first conductive blocks (111) in one first binding assembly (11) in one-to-one correspondence. The expansion rate of the first circuit board (1) is less than the expansion rate of the second circuit board (2); the second conductive blocks (211) in the second binding assembly (21) overlap the first conductive blocks (111) bound and connected thereto, and the change rate of the overlapping state of the second binding assembly (21) in the first direction is less than 0.102%.

FIG. 1

EP 4 394 493 A1

**Description**

TECHNICAL FIELD

The present disclosure relates to the field of display technologies, and in particular, to a circuit board assembly, a display module and a manufacturing method therefor, and a display apparatus.

BACKGROUND

With the development of display technologies, various display apparatuses are applied more and more widely in people's life. The display apparatus mainly includes a display panel and a main control board, the display panel and the main control board are bonded together through one or more flexible printed circuits (FPCs).

SUMMARY

In an aspect, a circuit board assembly is provided. The circuit board assembly includes a first circuit board and at least one second circuit board. The first circuit board includes at least one first bonding component, and a first bonding component includes a plurality of first conductive blocks sequentially arranged at intervals in a first direction. The at least one second circuit board includes at least one second bonding component, and a second bonding component includes a plurality of second conductive blocks sequentially arranged at intervals. The plurality of second conductive blocks in the second bonding component are bonded to the plurality of first conductive blocks in the first bonding component in one-to-one correspondence. An expansion ratio of the first circuit board is less than an expansion ratio of the second circuit board. Each second conductive block in a same second bonding component overlaps with a first conductive block bonded thereto, and a change ratio of an overlapping state of the second bonding component in the first direction is less than 0.102%.

Specifically, the change ratio of the overlapping state of the second bonding component in the first direction may truly reflect a bonding effect of the second circuit board and the first circuit board.

In some embodiments, the change ratio of the overlapping state of the second bonding component in the first direction is less than 0.059%.

In some embodiments, the change ratio of the overlapping state of the second bonding component in the first direction is less than 0.039%.

In some embodiments, the change ratio of the overlapping state of the second bonding component in the first direction is less than 0.028%.

In some embodiments, an overlapping width, in the first direction, of each second conductive block in the at least one second bonding component and a first conductive block bonded to the second conductive block is greater than or equal to two thirds of a width of the first conductive block.

In some embodiments, the first circuit board includes at least two first bonding components sequentially arranged at intervals in the first direction; and at least two second bonding components are included in the at least one second circuit board. A change ratio of an overlapping state of each of the at least two second bonding components in the first direction is equal.

In some embodiments, the first circuit board further includes at least one first dummy bonding component. In the first direction, the at least one first dummy bonding component and the at least one first bonding component are arranged side by side, and are alternately arranged from one side of the first circuit board to another side of the first circuit board. A first dummy bonding component includes a plurality of first dummy conductive blocks sequentially arranged at intervals in the first direction.

In some embodiments, a width of the first conductive block is 0.5 to 0.6 times a center-to-center distance between two adjacent first conductive blocks in the first bonding component; and a width of the second conductive block is 0.5 to 0.6 times a center-to-center distance between two adjacent second conductive blocks in the second bonding component.

In some embodiments, a center-to-center distance between two adjacent first conductive blocks in the first bonding component is in a range of 0.3 mm to 0.4 mm, inclusive; and a center-to-center distance between two adjacent second conductive blocks in the second bonding component is in a range of 0.3 mm to 0.4 mm, inclusive.

In some embodiments, a width of the first conductive block is in a range of 0.18 mm to 0.28 mm, inclusive; and/or, a width of the second conductive block is in a range of 0.15 mm to 0.2 mm, inclusive.

In some embodiments, an expansion ratio, at a unit temperature, of a center-to-center distance between two adjacent second conductive blocks in the second bonding component is 2 to 3 times an expansion ratio, at the unit temperature, of a center-to-center distance between two adjacent first conductive blocks in the first bonding component.

In some embodiments, the first bonding component further includes at least two first alignment structures, and the second bonding component further includes at least two second alignment structures; and a first alignment structure cooperates with a second alignment structure.

In some embodiments, a dimension of the first circuit board in the first direction is less than or equal to 350 mm; and a dimension of the second circuit board in the first direction is less than or equal to 200 mm.

In another aspect, a display module is provided. The display module includes a display panel and at least one circuit board assembly each according to any one of the above embodiments, and all second circuit boards of the circuit board assembly are bonded to a same side of the display panel.

In some embodiments, the display panel includes at least one third bonding component, and a third bonding component includes a plurality of third conductive blocks sequentially arranged at intervals in the first direction; the at least one second circuit board further includes at least one fourth bonding component, a fourth bonding component includes a plurality of fourth conductive blocks sequentially arranged at intervals; and the plurality of fourth conductive blocks in the fourth bonding component are bonded to the plurality of third conductive blocks in the third bonding component in one-to-one correspondence. An overlapping width, in the first direction, of each fourth conductive block in the at least one fourth bonding component and a third conductive block bonded to the fourth conductive block is greater than or equal to two thirds of a width of the third conductive block.

In another aspect, another display module is provided. The display module includes a display panel and a circuit board assembly located on a side of the display panel and bonded to the display panel. The circuit board assembly includes a first circuit board and a plurality of second circuit boards. The first circuit board includes a plurality of first bonding components, and a first bonding component includes a plurality of first conductive blocks sequentially arranged at intervals in a first direction. Each second circuit board includes at least one second bonding component, a second bonding component includes a plurality of second conductive blocks sequentially arranged at intervals; and the plurality of second conductive blocks in the second bonding component are bonded to the plurality of first conductive blocks in the first bonding component in one-to-one correspondence. An expansion ratio of the first circuit board is less than an expansion ratio of the second circuit board; and each second conductive block in a same second bonding component overlaps with a first conductive block bonded thereto; and a change ratio of an overlapping state, in the first direction, of a second conductive block corresponding to a middle position of the second bonding component is less than 0.050%.

In some embodiments, the change ratio of the overlapping state, in the first direction, of the second conductive block corresponding to the middle position of the second bonding component is less than 0.039%.

In some embodiments, the change ratio of the overlapping state, in the first direction, of the second conductive block corresponding to the middle position of the second bonding component is less than 0.028%.

In some embodiments, a change ratio of an overlapping state of the second bonding component in the first direction is less than 0.102%.

Specifically, the change ratio of the overlapping state of the second bonding component in the first direction may truly reflect a bonding effect of the second circuit board and the first circuit board.

In some embodiments, a change ratio of an overlapping state of the second bonding component in the first direction is less than 0.059%.

In some embodiments, a change ratio of an overlapping state of the second bonding component in the first direction is less than 0.039%.

In some embodiments, a change ratio of an overlapping state of the second bonding component in the first direction is less than 0.028%.

In some embodiments, the second circuit board includes a first end bonded to the first circuit board and a second end connected to the display panel. In a direction pointing from a bisecting plane of the first circuit board to an edge of the first circuit board, as for all second circuit boards, deviations between midpoints of first ends and midpoints of respective second ends in the first direction gradually increase.

In some embodiments, in a same second circuit board, a midpoint of a first end is closer to the bisecting plane of the first circuit board than a midpoint of a second end.

In some embodiments, as for each of all second bonding components, a change ratio of an overlapping state, in the first direction, of a second conductive block close to a bisecting plane of the second bonding component is same.

In some embodiments, the display panel includes at least one third bonding component, and a third bonding component includes a plurality of third conductive blocks sequentially arranged at intervals in the first direction. At least one second circuit board further includes at least one fourth bonding component, a fourth bonding component includes a plurality of fourth conductive blocks sequentially arranged at intervals; and the plurality of fourth conductive blocks in the fourth bonding component are bonded to the plurality of third conductive blocks in the third bonding component in one-to-one correspondence. An overlapping width, in the first direction, of each fourth conductive block in the at least one fourth bonding component and a third conductive block bonded to the fourth conductive block is greater than or equal to two thirds of a width of the third conductive block.

In some embodiments, an overlapping width, in the first direction, of each second conductive block in at least one second bonding component and a first conductive block bonded to the second conductive block is greater than or equal to two thirds of a width of the first conductive block.

In some embodiments, the first circuit board includes at least two first bonding components sequentially arranged at intervals in the first direction; at least one second circuit board includes at least two second bonding components. A change ratio of an overlapping state of each of the at least two second bonding components in the first direction is equal.

In some embodiments, the first circuit board further includes at least one first dummy bonding component; in the first direction, the at least one first dummy bonding component and at least one first bonding component are arranged side by side, and are alternately arranged from one side of the first circuit board to another side of the first circuit board. A first dummy bonding component includes a plurality of first dummy conductive blocks sequentially arranged at intervals in the first direction.

In some embodiments, a width of the first conductive block is 0.5 to 0.6 times a center-to-center distance between two adjacent first conductive blocks in the first bonding component; and a width of the second conductive block is 0.5 to 0.6 times a center-to-center distance between two adjacent second conductive blocks in the second bonding component.

In some embodiments, a center-to-center distance between two adjacent first conductive blocks in the first bonding component is in a range of 0.3 mm to 0.4 mm, inclusive; and a center-to-center distance between two adjacent second conductive blocks in the second bonding component is in a range of 0.3 mm to 0.4 mm, inclusive.

In some embodiments, a width of the first conductive block is in a range of 0.18 mm to 0.28 mm, inclusive; and/or, a width of the second conductive block is in a range of 0.15 mm to 0.2 mm, inclusive.

In some embodiments, an expansion ratio, at a unit temperature, of a center-to-center distance between two adjacent second conductive blocks in the second bonding component is 2 to 3 times an expansion ratio, at the unit temperature, of a center-to-center distance between two adjacent first conductive blocks in the first bonding component.

In some embodiments, the first bonding component further includes at least two first alignment structures, and the second bonding component further includes at least two second alignment structures; a first alignment structure cooperates with a second alignment structure.

In some embodiments, a dimension of the first circuit board in the first direction is less than or equal to 350 mm; and a dimension of the second circuit board in the first direction is less than or equal to 200 mm.

In yet another aspect, a display apparatus is provided. The display apparatus includes the display module as described in any one of the above embodiments.

In yet another aspect, a method for manufacturing a display module is provided, the method includes: obtaining a second expansion ratio of a second circuit board at a unit temperature; determining a second preshrinking ratio according to the second expansion ratio, so that at least one second circuit board is fabricated, the at least one second circuit board including at least one second bonding component, and a second bonding component including a plurality of second conductive blocks sequentially arranged at intervals; providing a first circuit board, the first circuit board including at least one first bonding component, and a first bonding component including a plurality of first conductive blocks sequentially arranged at intervals in a first direction; aligning a first bonding component with a second bonding component; providing a conductive adhesive between the first bonding component and the second bonding component; and pressing the first bonding component and the second bonding component with a preset pressure intensity after the first bonding component and the second bonding component are heated to a preset temperature, so that the plurality of second conductive blocks in the second bonding component are bonded to the plurality of first conductive blocks in the first bonding component in one-to-one correspondence. Each second conductive block in a same second bonding component overlaps with a first conductive block bonded thereto; and a change ratio of an overlapping state, in the first direction, of a second conductive block corresponding to a middle position of the second bonding component is less than 0.102%.

In some embodiments, providing the first circuit board includes: obtaining a first expansion ratio of a first circuit board at a unit temperature; and determining a first preshrinking ratio according to the first expansion ratio, so that the first circuit board is fabricated. A change ratio of an overlapping state of the second bonding component in the first direction is less than 0.039%.

In some embodiments, aligning the first bonding component with the second bonding component includes: making a bisecting plane of the second bonding component be coincided with a bisecting plane of the first bonding component.

In some embodiments, the first bonding component further includes at least two first alignment structures, and the second bonding component further includes at least two second alignment structures. Aligning the first bonding component with the second bonding component includes: aligning the at least two second alignment structures in the second bonding component with the at least two first alignment structures in the first bonding component, respectively.

In some embodiments, the preset pressure intensity is in a range of 0.1 MPa to 0.4 MPa, inclusive.

In yet another aspect, a method for manufacturing another display module is provided, the method includes: obtaining a first expansion ratio of a first circuit board at a unit temperature; determining a first preshrinking ratio according to the first expansion ratio, so that a first circuit board is fabricated, the first circuit board including at least one first bonding component, and a first bonding component including a plurality of first conductive blocks sequentially arranged at intervals in a first direction; providing at least one second circuit board, the at least one second circuit board including at least one second bonding component, and a second bonding component including a plurality of second conductive blocks sequentially arranged at intervals; aligning the first bonding component with the second bonding component; providing a conductive adhesive between the first bonding component and the second bonding component; and pressing the first bonding component and the second bonding component with a preset pressure intensity after the first bonding component and the second bonding component are heated to a preset temperature, so that the plurality of second conductive blocks in the second bonding component are bonded to the plurality of first conductive blocks in the first bonding component in one-to-one correspondence. Each second conductive block in a same second bonding component overlaps with a first conductive block bonded thereto; and a change ratio of an overlapping state, in the first direction, of a second conductive block corresponding to a middle position of the second bonding component is less than 0.050%.

In some embodiments, the at least one second circuit board includes at least one fourth bonding component, and a fourth bonding component includes a plurality of fourth conductive blocks sequentially arranged at intervals; before aligning the first bonding component with the second bonding component, the manufacturing method further includes: providing a display panel, the display panel including at least one third bonding component, and a third bonding component including a plurality of third conductive blocks sequentially arranged at intervals in the first direction; aligning the third bonding component with the fourth bonding component; providing a conductive adhesive between the third bonding component and the fourth bonding component; and pressing the third bonding component and the fourth bonding component with a preset pressure after the third bonding component and the fourth bonding component are heated to a preset temperature, so that the plurality of fourth conductive blocks in the fourth bonding component are bonded to the plurality of third conductive blocks in the third bonding component in one-to-one correspondence. An overlapping width, in the first direction, of each fourth conductive block in the at least one fourth bonding component and a third conductive block bonded to the fourth conductive block is greater than or equal to two thirds of a width of the third conductive block.

In some embodiments, the preset temperature is in a range of 150°C to 250°C, inclusive; and the preset pressure is in a range of 20 N to 40 N, inclusive.

In some embodiments, providing the at least one second circuit board includes: obtaining a second expansion ratio of a second circuit board at the unit temperature; and determining a second preshrinking ratio according to the second expansion ratio, so that the at least one second circuit board is fabricated. The change ratio of the overlapping state, in the first direction, of the second conductive block corresponding to the middle position of the second bonding component is less than 0.039%.

In some embodiments, aligning the first bonding component with the second bonding component includes: making a bisecting plane of a second bonding component at a middle position be coincided with a bisecting plane of a first bonding component.

In some embodiments, the first bonding component further includes at least two first alignment structures, and the second bonding component further includes at least two second alignment structures; aligning the first bonding component with the second bonding component includes: aligning two second alignment structures with a farthest distance in the first direction in all second alignment structures with two corresponding first alignment structures, respectively.

In some embodiments, the preset pressure intensity is in a range of 0.1 MPa to 0.4 MPa, inclusive.

BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art can obtain other drawings according to these accompanying drawings. In addition, the accompanying drawings in the following description may be regarded as schematic diagrams, and are not limitations to actual sizes of products, actual processes of methods or actual timings of signals involved in the embodiments of the present disclosure.

FIG. 1 is a structural diagram of a circuit board assembly, in accordance with some embodiments;
FIG. 2 is a partial structural diagram of a first circuit board located in the E region in FIG. 1;
FIG. 3 is a structural diagram of a second circuit board located in the E region in FIG. 1;
FIG. 4A is a structural diagram of the N portion in FIG. 1;
FIG. 4B is a diagram illustrating a positional relationship between a first conductive block and a second conductive block, in accordance with some embodiments;
FIG. 5A is a structural diagram of another circuit board assembly, in accordance with some embodiments;
FIG. 5B is a structural diagram of yet another circuit board assembly, in accordance with some embodiments;
FIG. 6 is a structural diagram of yet another circuit board assembly, in accordance with some embodiments;
FIG. 7A is a structural diagram of a display module, in accordance with some embodiments;
FIG. 7B is a structural diagram of another display module, in accordance with some embodiments;
FIG. 7C is a structural diagram of yet another display module, in accordance with some embodiments;
FIG. 8A is a structural diagram of a display panel, in accordance with some embodiments;
FIG. 8B is a structural diagram of the P portion in FIG. 8A;

FIG. 9 is a structural diagram of the O portion in FIG. 7A;

FIG. 10 is a structural diagram of a display apparatus, in accordance with some embodiments;

FIG. 11 is a flow diagram of a manufacturing method for a display module, in accordance with some embodiments;

FIG. 12 is a flow diagram of a manufacturing method for another display module, in accordance with some embodiments; and

FIG. 13 is a structural diagram of an FPC and a main control board after being bonded in the related art.

DETAILED DESCRIPTION

Technical solutions in some embodiments of the present disclosure will be described clearly and completely below with reference to the accompanying drawings. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "an example", "a specific example" or "some examples" are intended to indicate that specific features, structures, materials or characteristics related to the embodiment(s) or example(s) are included in at least one embodiment or example of the present disclosure. Schematic representation of the above term does not necessarily refer to the same embodiment(s) or example(s). In addition, specific features, structures, materials or characteristics may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, a feature defined with "first" or "second" may explicitly or implicitly include one or more of the features. In the description of the embodiments of the present disclosure, the term "a plurality of" or "the plurality of" means two or more unless otherwise specified.

In the description of the present disclosure, the numerical range of x to y includes the endpoint values (x and y) and all values therebetween.

In the description of some embodiments, the term "connected" and derivatives thereof may be used. For example, the term "connected" may be used in the description of some embodiments to indicate that two or more components are in direct physical or electrical contact with each other. The embodiments disclosed herein are not necessarily limited to the content herein.

The phrase "A and/or B" includes the following three combinations: only A, only B, and a combination of A and B.

As used herein, terms such as "about" or "substantially" include a stated value and an average value within an acceptable range of deviation of a particular value. The acceptable range of deviation is determined by a person of ordinary skill in the art in view of the measurement in question and the errors associated with the measurement of a particular quantity (i.e., the limitations of the measurement system). The description "one coincides with another" means that one absolutely coincides with another or one approximately coincides with another, the description that one approximately coincides with another means that the one and the another coincide within an acceptable range of deviation, and the acceptable range of deviation may be, for example, a deviation range within five percent of the size of an absolute overlapping area when the two absolutely coincide. The description that "A and B are equal" means that A and B are absolutely equal or A and B are approximately equal. The acceptable range of deviation of A and B being approximately equal may be, for example, a deviation range within five percent of the stated numerical value of B. In addition, the term "about" may, for example, refer to a stated numerical value, or plus or minus ten percent from the stated numerical value.

Exemplary embodiments are described herein with reference to sectional views and/or plan views as idealized exemplary drawings. In the accompanying drawings, thickness of layers and sizes of regions are enlarged for clarity. Variations in shapes relative to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Therefore, the regions shown in the accompanying drawings are schematic in nature, and their shapes are not intended to show actual shapes of regions in a device, and are not intended to limit the scope of the exemplary embodiments.

In addition, the term "bisecting plane" as used herein refers to a plane perpendicular to a substrate of a circuit board and parallel to a direction in which a conductive block extends. For example, a bisecting plane of a first conductive block refers to a plane perpendicular to a substrate of a first circuit board and parallel to a direction in which the first conductive block extends, and the first conductive block is symmetrical with respect to the plane. Similarly, a bisecting plane of a second conductive block refers to a plane perpendicular to a substrate of a second circuit board and parallel to a direction in which the second conductive block extends, and the second conductive block is symmetrical with respect to the plane. As used herein, the term "center-to-center distance between A and B" or "center-to-center distance between two A" refers to a distance between bisecting planes of the two (A and B, or two A).

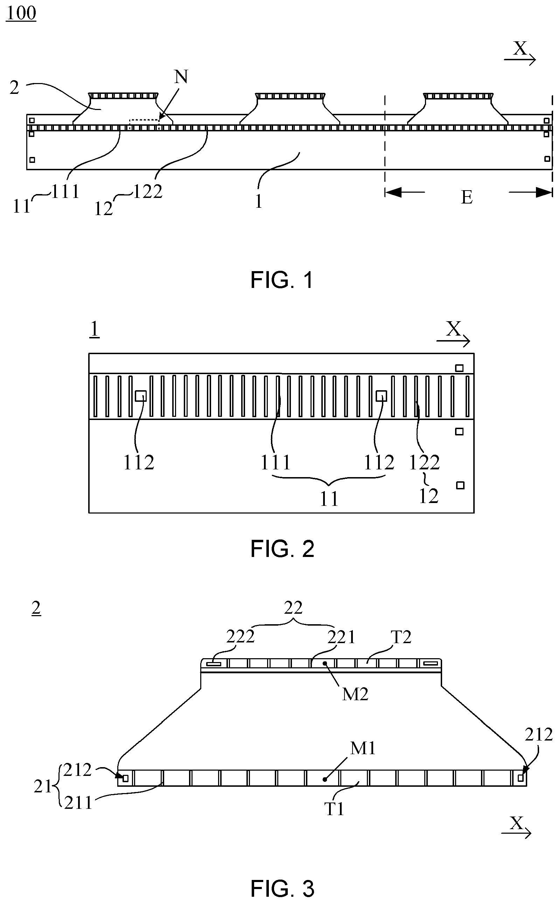

Referring to FIG. 1, some embodiments of the present disclosure provide a circuit board assembly 100. The circuit board assembly 100 includes a first circuit board 1 and at least one second circuit board 2. An expansion ratio of the first circuit board 1 is less than an expansion ratio of the second circuit board 2. Here, it may be understood that, an expansion ratio of the substrate of the first circuit board 1 is less than an expansion ratio of the substrate of the second circuit board 2; or an overall expansion ratio of all film layers in a region, for being connected to the second circuit board 2, of the first circuit board 1 is less than an overall expansion ratio of all film layers in a region, for being connected to the first circuit board 1, of the second circuit board 2.

For example, the first circuit board 1 may be a main control board of a display apparatus, and the second circuit board 2 may be an FPC of the display apparatus. It can be understood that, this example is only illustrative. That is, it is not limited to the main control board and the FPC in the above example, as long as the first circuit board 1 and the second circuit board 2 of the circuit board assembly 100 provided in the present disclosure have different expansion ratios. In addition, the circuit board assembly 100 may be applied to various electronic devices, which is not limited to the display apparatus in the above example.

Referring to FIG. 2, the first circuit board 1 includes at least one first bonding component 11, and a first bonding component 11 includes a plurality of first conductive blocks 111 that are sequentially arranged at intervals in a first direction X. Referring to FIG. 3, the second circuit board 2 includes at least one second bonding component 21, and a second bonding component 21 includes a plurality of second conductive blocks 211 that are sequentially arranged at intervals. The plurality of second conductive blocks 211 in the second bonding component 21 are bonded to the plurality of first conductive blocks 111 in the first bonding component 11 in one-to-one correspondence.

Each second conductive block 211 in a same second bonding component 21 overlaps with a first conductive block 111 bonded thereto, and a change ratio of an overlapping state of the second bonding component 21 in the first direction X is less than 0.102%.

It is worth noting that, for the same second circuit board 2, the change ratio of the overlapping state thereof refers to an amount of change in a relative position between feature points at same positions on the second conductive block 21 and the first conductive block 11 that are bonded under a unit length. That is, a ratio of a difference of a distance between feature points at same positions (which constitute a first group of feature points) on two second conductive blocks 211 and a distance between feature points at same positions (which constitute a second group of feature points) on two first conductive blocks 111 that correspond to the two second conductive blocks 211 to the distance between the first group of feature points is the change ratio of the overlapping state of the second bonding component 21 in the first direction X.

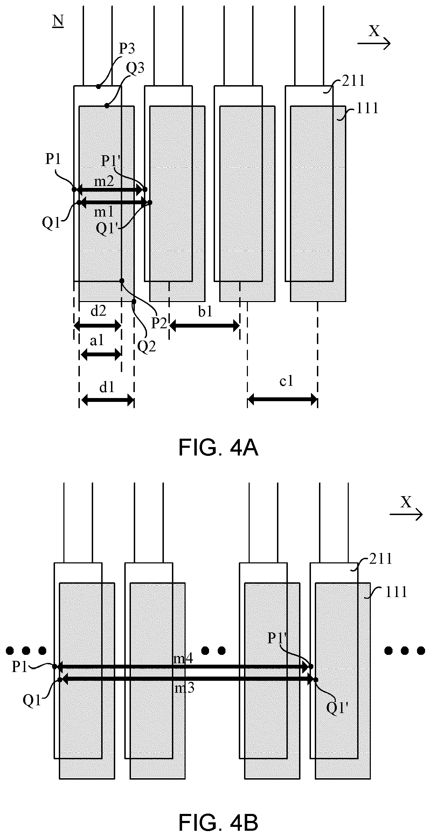

As shown in FIG. 4A, positions of the two feature points in the second group of feature points on the two second conductive blocks 211 correspond to positions of the two feature points in the first group of feature points on the two first conductive blocks 111. For example, in a case where the two feature points (P1, P1') in the second group of feature points are on left sides of the two second conductive blocks 211 respectively, the two feature points (Q1, Q1') in the first group of feature points are also on left sides of the two first conductive blocks 111 respectively. It can be understood that, the term "left side" here refers to a side of the left of the corresponding conductive block in the illustrated orientation. In addition, the feature point may be located at any position on the second conductive block 211, and is not limited to the left side. For example, the feature point may also be located on a right side of the conductive block or the bisecting plane of the conductive block.

For example, the feature point on the second conductive block 211 may be a first midpoint P1 on a side, perpendicular to the first direction X, of a contact surface of the second conductive block 211 (i.e., a surface of the second conductive block 211 being in contact with the first conductive block 111); and in this case, the feature point on the first conductive block 111 is a second midpoint Q1 on a side, perpendicular to the first direction X and close to the first midpoint P1, of a contact surface of the first conductive block 111 (i.e., a surface of the first conductive block 111 being in contact with the second conductive block 211).

As another example, the feature point on the second conductive block 211 may be a first end point P2 on another side, perpendicular to the first direction X, of the contact surface of the second conductive block 211; and in this case, the feature point on the first conductive block 111 is a second end point Q2 on another side, perpendicular to the first direction X and close to the first end point P2, of the contact surface of the first conductive block 111, and the second end point Q2 is close to the first end point P2.

As another example, the feature point on the second conductive block 211 may be a third midpoint P3 on a side, parallel to the first direction X, of the contact surface of the second conductive block 211; and in this case, the feature point on the first conductive block 111 is a fourth midpoint Q3 on a side, parallel to the first direction X and close to the third midpoint P3, of the contact surface of the first conductive block 111.

Some embodiments of the present disclosure will be described below by considering an example in which the feature point on the second conductive block 211 is P1 and the feature point on the first conductive block 111 is Q1.

With continued reference to FIG. 4A, in a case where the distance between the first group of feature points on the two second conductive blocks 211 in the first direction X is a distance m2 between the first group of feature points (i.e., P1 and P1') on two adjacent second conductive blocks 211 in the first direction X, the distance between the second group of feature points on the two first conductive blocks 111 in the first direction X is a distance m1 between the second group of feature points (i.e., Q1 and Q1') on two adjacent first conductive blocks 111 in the first direction X. In this case, the change ratio $\rho$ of the overlapping state, in the first direction X, of the second bonding component 21 corresponding to the two second conductive blocks 211 satisfies that,

$$\rho = \frac{m2 - m1}{m2}$$

. It is worth noting that, the manner for selecting the feature points in FIG. 4A is for convenience of describing the meaning of the change ratio of the overlapping state, and in an actual measurement, this manner is not generally adopted in view of error factors.

Referring to FIG. 4B, in a case where the distance between the first group of feature points on the two second conductive blocks 211 in the first direction X is a distance m4 between the first group of feature points (i.e., P1 and P1') on two second conductive blocks 211 spaced by multiple second conductive blocks 211 (e.g., half of all second conductive blocks 211 in the second bonding component 21) in the first direction X, the distance between the second group of feature points on the two first conductive blocks 111 in the first direction X is a distance m3 between the second group of feature points (i.e., Q1 and Q1') on two first conductive blocks 111 spaced by multiple first conductive blocks 111 (e.g., half of all second conductive blocks 211 in the second bonding component 21) in the first direction X. In this case, the change ratio $\rho$ of the overlapping state, in the first direction X, of the second bonding component 21 corresponding to the two second conductive blocks 211 satisfies that,

$$\rho = \frac{m4 - m3}{m4}$$

. With such a calculation, it helps avoid a problem that an actually measured numerical value (i.e., the change ratio of the overlapping state) has a large deviation due to a relatively large distortion and deformation of partial regions in a bonding process of the first circuit board 1 and the second circuit board 2. In some other embodiments, the two conductive blocks may be spaced by more conductive blocks, thereby enabling a measurement result relatively accurate. In addition, the conductive blocks, on which the feature points are located, may be, for example, selected from conductive blocks except outermost conductive blocks on the bonding component, thereby avoiding a problem of a large measurement error caused by a severe distortion and deformation of the outermost conductive blocks.

The change ratio of the overlapping state reflects a bonding effect of the second circuit board 2 and the first circuit board 1, and the smaller an absolute value of the change ratio of the overlapping state, the better the bonding effect of the first circuit board 1 and the second circuit board 2. It will be noted that, for a same circuit board 2, the change ratio of the overlapping state is theoretically unchanged, but the manner for selecting the feature points may be different due to process reasons. For example, the measured change ratio of the overlapping state cannot reflect the bonding effect of the first circuit board 1 and the second circuit board 2 in a case where positions of the two groups of feature points are adjacent or close to each other.

In practical applications, for the same second circuit board, the number of the second conductive blocks 21 is generally greater than or equal to fifteen. In order to ensure the accuracy of the measured change ratio of the overlapping state, the first group of feature points and the second group of feature points are selected through the following manner. A second conductive block 21 close to the left and a second conductive block 21 close to the right that are in the second circuit board 2 are selected as two second conductive block 21 on which the first group of feature points are located; and based on this, two first conductive blocks 11, which are bonded to the two second conductive blocks 21, in the first circuit board 1 are selected as two first conductive blocks 11 on which the second group of feature points are located. The phrase "the second conductive block 21 close to the left" may refer to a second conductive block 21 located at the right of a leftmost second conductive block 21, and there are four second conductive blocks 21 between the second conductive block 21 and the leftmost second conductive block 21; and the phrase "the second conductive block 21 close to the right" may refer to a second conductive block 21 located at the left of a rightmost second conductive block 21, and there are four second conductive blocks 21 between the second conductive block 21 and the rightmost second conductive block 21. By selecting the feature points in this manner, it may be possible to avoid affecting the measurement of the change ratio of the overlapping state because a drastic change of the overlapping state may occur when conductive blocks are too close to edges. In this way, the change ratio of the overlapping state may truly reflect the bonding effect of the second circuit board 2 and the first circuit board 1 by selecting the feature points.

In the related art, for two circuit boards (e.g., the main control board and the FPC) having different expansion ratios, after the two circuit boards are bonded, a connection structure (including two conductive blocks that are respectively located in the two circuit boards and are bonded) at a position far away from a bisecting plane of any one circuit board is easy to have problems such as misalignment and unreliable bonding. In addition, the farther a position is away from the bisecting plane of any one circuit board, the more serious the misalignment of the connection structure is.

For example, the expansion ratio of the second circuit board 2 at a unit temperature is 3 / 437500, and the expansion ratio of the first circuit board 1 at the unit temperature is 1 / 437500. During the bonding process of the second circuit board 2 and the first circuit board 1, a temperature needs to be increased from a normal temperature (e.g., 25°C) to a preset temperature (e.g., 250°C). In this case, the change ratio of the overlapping state of the second bonding component 21 in the first direction X is greater than 0.102. A calculation manner of the change ratio of the overlapping state may be referred to the following formula:

$$\frac{\dfrac{3}{437500} \times 225 - \dfrac{1}{437500} \times 225}{1 + \dfrac{3}{437500} \times 225} \approx 0.103\%$$

.

It will be noted that, the term "expansion ratio at the unit temperature" mentioned in the present disclosure refers to an expansion amount of a center-to-center distance between two adjacent second conductive blocks 211 (or two adjacent first conductive blocks 111) at the unit temperature (e.g., 1°C).

In the circuit board assembly 100 provided in the embodiments of the present disclosure, the change ratio of the overlapping state of the second bonding component 21 in the first direction X is less than 0.102%. That is, the second bonding component 21 of the circuit board assembly 100 provided in the present disclosure has been preshrunk (for example, in a case where one first circuit board and one second circuit board are included in the circuit board assembly 100, and the bisecting plane of the first circuit board coincides with the bisecting plane of the second circuit board, at least the second bonding component 21 in the second circuit board with a relatively large expansion ratio has been preshrunk; and as another example, in a case where one first circuit board and at least two second circuit boards are included in the circuit board assembly 100, and the bisecting plane of at least one second circuit board does not coincide with the bisecting plane of the first circuit board, each second bonding component 21 in the at least one second circuit board and the first bonding component 11 in the first circuit board have been preshrunk). With such a design, the change ratio of the overlapping state of the second bonding component 21 in the first direction X may be less than 0.102%, so that two conductive blocks in each group of connection structures may be in a good aligned and bonded state. As a result, a bonding yield of the circuit board assembly 100 may be improved.

It will be noted that, in some examples, ideally, the change ratio of the overlapping state may be equal to 0, so that the two conductive blocks bonded to each other can completely overlap with each other. Of course, in general, the change ratio of the overlapping state is not equal to 0 due to the bonding error. For example, the change ratio of the overlapping state is in the range of 0 to 0.102%.

In some embodiments, the change ratio of the overlapping state of the second bonding component 21 in the first direction X is less than 0.059%.

It will be noted that, in some implementations, the expansion ratio of the second circuit board 2 at the unit temperature is 1 / 175000, and the expansion ratio of the first circuit board 1 at the unit temperature is 1 / 437500. During the bonding process of the second circuit board 2 and the first circuit board 1, a temperature needs to be increased from the normal temperature (e.g., 25°C) to a preset temperature (e.g., 200°C). In this case, the change ratio of the overlapping state of the second bonding component 21 in the first direction X is greater than 0.059%. A calculation manner of the change ratio of the overlapping state may be referred to the following formula:

$$\frac{\dfrac{1}{175000} \times 175 - \dfrac{1}{437500} \times 175}{1 + \dfrac{1}{175000} \times 175} \approx 0.060\%$$

.

In the circuit board assembly 100 provided in the embodiments of the present disclosure, since at least one circuit board has been preshrunk, the change ratio of the overlapping state of the second bonding component 21 in the first direction X may be less than 0.059%. As a result, the two conductive blocks in each group of connection structures may be in the good aligned and bonded state, and thus the bonding yield of the circuit board assembly 100 may be further improved.

In some embodiments, the change ratio of the overlapping state of the second bonding component 21 in the first direction X is less than 0.039%.

A grade of a material of the first circuit board 1 may be FR-4. The second circuit board 2 may include a polyimide (PI) substrate and a metal wiring layer disposed on the PI substrate. FR-4 is a grade code of a flame-resistant material, and refers to a material specification that a resin material is capable of self-extinguishing after combustion. FR-4 is not a name of a material, but the grade of the material. Therefore, materials of FR-4 grade generally used in the circuit board are of various types, but most of the materials are composite materials made of so-called tetra-functional epoxy resin, filler and fiberglass.

In this case, after the temperature is increased from the normal temperature (25°C) to a temperature that is in a range of 150°C to 250°C, an expansion proportion between two adjacent first conductive blocks 111 in the first bonding component 11 of the first circuit board 1 is about 0.04%, and an expansion proportion between two adjacent second conductive blocks 211 in the second bonding component 21 of the second circuit board 2 is in a range of 0.08% to 0.12%.

Based on the above, the expansion proportions each are divided by a temperature change value (e.g., 175°C), and thus it may be obtained that the expansion ratio of the first circuit board 1 at the unit temperature is 1 / 437500, and the expansion ratio of the second circuit board 2 at the unit temperature is 1 / 218750.

It can be seen from the above content that, the change ratio of the overlapping state of the second bonding component 21 in the first direction X is greater than 0.039%. A calculation manner of the change ratio of the overlapping state may be referred to the following formula:

$$\frac{0.08\% - 0.04\%}{(1 + 0.08\%)} \approx 0.040\%$$

In the circuit board assembly 100 provided in the embodiments of the present disclosure, since at least one circuit board has been preshrunk, the change ratio of the overlapping state of the second bonding component 21 in the first direction X may be less than 0.039%. Therefore, the two conductive blocks in each group of connection structures may be in a better aligned and bonded state, and thus the bonding yield of the circuit board assembly 100 may be further improved.

In some embodiments, the change ratio of the overlapping state of the second bonding component 21 in the first direction X is less than 0.028%. In some implementations, the expansion ratio of the second circuit board 2 at the unit temperature is about 1 / 218750, and the expansion ratio of the first circuit board 1 at the unit temperature is 1 / 437500. During the bonding process of the second circuit board 2 and the first circuit board 1, a temperature needs to be increased from the normal temperature (e.g., 25°C) to a preset temperature (e.g., 150°C). In this case, the change ratio of the overlapping state of the second bonding component 21 in the first direction X is greater than 0.028%. A calculation manner of the change ratio of the overlapping state may be referred to the following formula:

$$\frac{\frac{1}{218750} \times 125 - \frac{1}{437500} \times 125}{1 + \frac{1}{218750} \times 125} \approx 0.029\%$$

In the circuit board assembly 100 provided in the embodiments of the present disclosure, since at least one circuit board has been preshrunk, the change ratio of the overlapping state of the second bonding component 21 in the first direction X may be less than 0.028%. Therefore, the two conductive blocks in each group of connection structures may be in the good aligned and bonded state, and thus the bonding yield of the circuit board assembly 100 may be improved more effectively. In some embodiments, the change ratio of the overlapping state of the second bonding component 21 in the first direction X is less than 0.014%.

In this case, since the circuit board assembly 100 provided in the present disclosure has been preshrunk, the change ratio of the overlapping state of the second bonding component 21 in the first direction X may be less than 0.014%. Therefore, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.005%.

In this case, since the circuit board assembly 100 provided in the present disclosure has been preshrunk, the change ratio of the overlapping state of the second bonding component 21 in the first direction X may be less than 0.005%. Therefore, the two conductive blocks in each group of connection structures may be in the good aligned and bonded state, and thus the bonding yield of the circuit board assembly 100 may be improved more effectively.

In some implementations, a dimension of the first circuit board 1 in the first direction X may be less than or equal to 350 mm, such as in a range of 250 mm to 300 mm; or the dimension of the first circuit board 1 in the first direction X may be approximately equal to a dimension of the second circuit board 2 in the first direction X. The dimension L1 of the second circuit board 2 in the first direction X may be less than or equal to 200 mm, such as in a range of 40 mm to 80 mm.

Based on the embodiments described above, for example, with continued reference to FIG. 4A, as for at least one second bonding component 21 in all second bonding components 21, an overlapping width a1, in the first direction X, of each second conductive block 211 in the second bonding component 22 and a first conductive block 111 bonded to the second conductive block 211 is greater than or equal to two thirds of a width d1 of the first conductive block 111 (that is, $a1 \geq \frac{2}{3} d1$ ).

A width of a conductive block (e.g., the width of the first conductive block 111) refers to a length of the conductive block (i.e., the first conductive block 111) in the first direction X.

In addition, FIG. 4A only illustrates a relative positional relationship between an overlapping portion of the second conductive block 211 and the first conductive block 111, and the width of the first conductive block 111; dimensions and shapes of the two conductive blocks are not limited.

It is worth noting that, after the two circuit boards (e.g., the main control board and the FPC) having different expansion ratios are bonded, at least one group of connection structures is prone to have serious misalignment and unreliable bonding. In this case, it easily results in a contact area of two conductive blocks in a same group of connection structures being too small, for example, an electrical connection failure is easy to occur in the subsequent process. In addition, it easily results in an excessive small insulation area between two conductive blocks that are respectively located in two adjacent groups of connection structures and respectively located in two circuit boards, for example, a short circuit is easy to occur between the two conductive blocks that should not be connected.

In the circuit board assembly 100 provided in the embodiments of the present disclosure, as for one or more second circuit boards 2 in all second circuit boards 2, the overlapping width a1, in the first direction X, of each second conductive block 211 in the second bonding component 22 of the second circuit board 2 and the first conductive block 111 bonded to the second conductive block 211 is greater than or equal to two thirds of the width d1 of the first conductive block 111, so that the contact area of two bonded conductive blocks in the same group of connection structures (i.e., the first conductive block 111 and the second conductive block 211 connected thereto) is relatively large. As a result, the failure of electrical connection between the two conductive blocks is not easy to occur. Moreover, since the two conductive blocks in the same group of connection structures are accurately aligned, it may ameliorate the problem that the short circuit is easy to occur between the two conductive blocks that are respectively located in two adjacent groups of connection structures and respectively located in the two circuit boards.

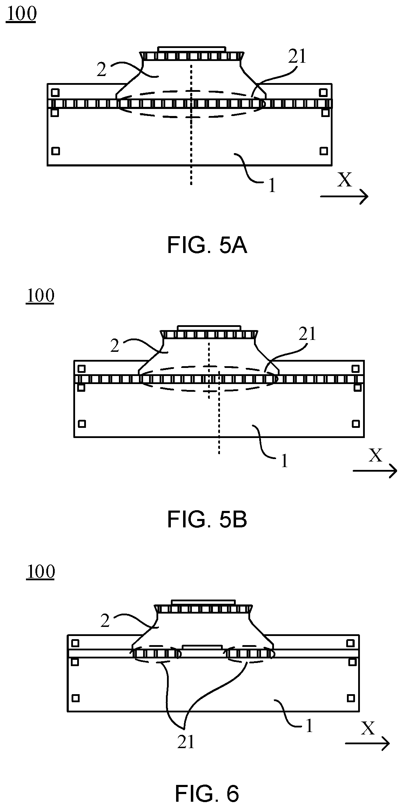

For example, referring to FIG. 5A, in a case where the circuit board assembly 100 includes one second circuit board 2, and the second circuit board 2 includes one second bonding component 21, before alignment and bonding, a design value of the center-to-center distance between any two adjacent second conductive blocks 211 in the second bonding component 21 may be reduced, so that the overlapping width a1, in the first direction X, of the second conductive block 211 and the first conductive block 111 that are aligned and then bonded is greater than or equal to two thirds of the width d1 of the first conductive block 111.

For example, during the bonding process of the second bonding component 21 and the first bonding component 11, the second bonding component 21 is aligned with the first bonding component 11 first, so that a bisecting plane of the first bonding component 11 coincides with a bisecting plane of the second bonding component 21; then, a conductive adhesive is provided between the first bonding component 11 and the second bonding component 21; next, the first bonding component 11 and the second bonding component 21 are heated to the preset temperature (e.g., 150°C to 250°C), and in this case, the center-to-center distance between any two adjacent second conductive blocks 211 in the second bonding component 21 increases from the reduced design value to a value that is equal to or approaches a center-to-center distance between any two adjacent first conductive blocks 111 in the first bonding component 11 after expanding; and finally, the first bonding component 11 and the second bonding component 21 are pressed with a preset pressure intensity (e.g., 0.1 MPa to 0.4 MPa), so that the plurality of second conductive blocks 211 in the second bonding component 21 are bonded to the plurality of first conductive blocks 111 in the first bonding component 11 in one-to-one correspondence.

The bisecting plane of the first bonding component 11 may refer to a plane perpendicular to the substrate of the first circuit board 1 and parallel to the direction in which the first conductive block 111 extends, and the first bonding component 11 is symmetrical with respect to the bisecting plane of the first bonding component 11. Similarly, the bisecting plane of the second bonding component 21 may refer to a plane perpendicular to the substrate of the second circuit board 2 and parallel to the direction in which the second conductive block 211 extends, and the second bonding component 21 is symmetrical with respect to the bisecting plane of the second bonding component 21.

It can be understood that, as the first bonding component 11 and the second bonding component 21 are cooled together after being pressed, the center-to-center distance between the two adjacent second conductive blocks 211 in the second bonding component 21 and the center-to-center distance between the two adjacent first conductive blocks 111 in the first bonding component 11 decrease simultaneously, and finally the circuit board assembly 100 described above may be obtained. As for the circuit board assembly 100, the overlapping width a1, in the first direction X, of the second conductive block 211 and the first conductive block 111 that are aligned and then bonded is greater than or equal to two thirds of the width d1 of the first conductive block 111.

As another example, the circuit board assembly 100 includes at least one second circuit board 2, the at least one second circuit board includes at least two second bonding components 21 (for example, one second circuit board 2 includes two second bonding components 21 (as shown in FIG. 6); or two second circuit boards 2 each include one second bonding component 21); and the first circuit board 1 includes at least two first bonding components 11. In this case, a change ratio of an overlapping state of each of the at least two second bonding components 21 in the first direction X is equal. That is, the first circuit board 1 and all second circuit boards 2 in the circuit board assembly 100 provided in the present disclosure have been preshrunk, and thus the change ratio of the overlapping state of each second bonding component 21 in the first direction X is equal. In this case, a change trend of the overlapping of each second conductive block 211 in each second bonding component 21 and a first conductive block 111 is the same. As a result, it helps control a bonding yield of the second bonding component 21 and the first bonding component 11, and improves a production yield of the circuit board assembly 100.

Based on this, before the alignment and bonding, the design value of the center-to-center distance between any two adjacent first conductive blocks 111 in the first bonding component 11 and the design value of the center-to-center distance between any two adjacent second conductive blocks 211 in the second bonding component 21 are both reduced, and a reduced amount of the design value of the center-to-center distance between any two adjacent first conductive blocks 111 in the first bonding component 11 is less than a reduced amount of the design value of the center-to-center distance between any two adjacent second conductive blocks 211 in the second bonding component 21. In this way, the overlapping width a1, in the first direction X, of the second conductive block 211 and the first conductive block 111 that are bonded and then aligned is greater than or equal to two thirds of the width d1 of the first conductive block 111.

For example, during the bonding process of the at least two second bonding components 21 and the at least two first bonding components 11, each second bonding component 21 is aligned with a corresponding first bonding component 11 first, so that the bisecting plane of each first bonding component 11 coincides with the bisecting plane of the corresponding second bonding component 21; then, the conductive adhesive is provided between each first bonding component 11 and the corresponding second bonding component 21; next, all first bonding components 11 and all second bonding components 21 are heated to the preset temperature (e.g., 150°C to 250°C), and in this case, the center-to-center distance between any two adjacent second conductive blocks 211 in each second bonding component 21 after expanding is equal to the center-to-center distance between any two adjacent first conductive blocks 111 in the corresponding first bonding component 11 after expanding; and finally, the first bonding components 11 and the second bonding components 21 are pressed with the preset pressure intensity (e.g., 0.1 MPa to 0.4 MPa), so that the plurality of second conductive blocks 211 in each second bonding component 21 are bonded to the plurality of first conductive blocks 111 in the corresponding first bonding component 11 in one-to-one correspondence.

It can be understood that, as each first bonding component 11 and the corresponding second bonding component 21 are cooled together after being pressed, the center-to-center distance between two adjacent second conductive blocks 211 in the second bonding component 21 and the center-to-center distance between two adjacent first conductive blocks 111 in the corresponding first bonding component 11 decrease simultaneously, and finally the circuit board assembly 100 described above may be obtained. As for the circuit board assembly 100, the overlapping width a1, in the first direction X, of the second conductive block 211 and the first conductive block 111 that are aligned and then bonded is greater than or equal to two thirds of the width d1 of the first conductive block 111.

In a case where the number of the first conductive blocks 111 in the first bonding component 11 is an odd number, the bisecting plane of the first bonding component 11 may coincide with the bisecting plane of a first conductive block 111 located at a middle. In a case where the number of the first conductive blocks 111 in the first bonding component 11 is an even number, the bisecting plane of the first bonding component 11 may coincide with a symmetry plane of two first conductive blocks 111 located at the middle. That is, the two first conductive blocks 111 located at the middle are symmetrical with respect to the bisecting plane of the first bonding component 11. As shown in FIG. 5A, the number of the first conductive blocks 111 in the first bonding component 11 is twenty-six; and in this case, in the first direction X, the thirteenth conductive block 111 and the fourteenth first conductive block 111 are symmetrical with respect to the bisecting plane of the first bonding component 11.

It will be noted that, the bisecting plane of the first conductive block 111 refers to a plane perpendicular to the substrate of the first circuit board 1 and parallel to the direction in which the first conductive block 111 extends; and in addition, the first conductive block 111 is symmetrical with respect to the plane.

Similarly, in a case where the number of the second conductive blocks 211 in the second bonding component 21 is an odd number, the bisecting plane of the second bonding component 21 may coincide with the bisecting plane of a second conductive block 211 located at a middle. In a case where the number of the second conductive blocks 211 in the second bonding component 21 is an even number, the bisecting plane of the second bonding component 21 may coincide with a symmetry plane of two second conductive blocks 211 located at the middle. That is, the two second conductive blocks 211 located at the middle are symmetrical with respect to the bisecting plane of the second bonding component 21. As shown in FIG. 5A, the number of the second conductive blocks 211 in the second bonding component 21 is fourteen; and in this case, in the first direction X, the seventh second conductive block 211 and the eighth second conductive block 211 are symmetrical with respect to the bisecting plane of the second bonding component 21.

It will be noted that, the bisecting plane of the second conductive block 211 refers to a plane perpendicular to the substrate of the second circuit board 2 and parallel to the direction in which the second conductive block 211 extends; and in addition, the second conductive block 211 is symmetrical with respect to the plane.

In some embodiments, during the bonding process of the at least one second circuit board 2 and the first circuit board 1, a position of the bisecting plane of each second bonding component 21 remains unchanged, and a position of the bisecting plane of the first circuit board 1 remains unchanged. The bisecting plane of the first circuit board 1 is the plane perpendicular to the substrate of the first circuit board 1 and parallel to the direction in

23 **EP 4 394 493 A1** 24

which the first conductive block 111 extends; and in addition, the first circuit board 1 is symmetrical with respect to the plane. The bisecting plane of the first circuit board 1 may coincide with the bisecting plane of one first bonding component 11 of the first circuit board 1.

In some embodiments, referring to FIGS. 1 and 2, the first circuit board 1 further includes at least one first dummy bonding component 12. In the first direction X, the at least one first dummy bonding component 12 and the at least one first bonding component 11 are arranged side by side, and are alternately arranged from one side of the first circuit board 1 to the other side of the first circuit board 1. The first dummy bonding component 12 includes a plurality of first dummy conductive blocks 122 that are sequentially arranged at intervals in the first direction X.

With such a design, it may be possible to ameliorate a poor bonding caused by a segmental arrangement of first bonding components 11 in the first circuit board 1. As a result, after the second bonding component 21 is bonded to the first bonding component 11, a pressure on each group of connection structures is uniform, the connection is reliable, and a transmission of an electrical signal is stable.

In some embodiments, a center alignment deviation, in the first direction X, of a second conductive block 211 that is closest to the bisecting plane of the second bonding component 21 and a first conductive block 111 bonded to the second conductive block 211 is less than or equal to 0.01 mm.

The center alignment deviation is a distance between bisecting planes of two conductive blocks in the first direction X.

It will be noted that, in some examples, the second circuit board 2 may include at least one second dummy bonding component. In the first direction X, the at least one second dummy bonding component and the at least one second bonding component 21 are arranged side by side, and are alternately arranged from one side of the second circuit board 2 to the other side of the first circuit board 1. For example, the second circuit board 2 includes one second bonding component 21 and one second dummy bonding component located on a side of the second bonding component 21. As another example, the second circuit board 2 includes one second bonding component 21 and two second dummy bonding components that are located on two sides of the second bonding component 21, respectively.

In the case where the at least one second dummy bonding component is disposed in the second circuit board 2, the center alignment deviation is not affected by the second dummy bonding component.

In addition, the second dummy bonding component may include, for example, a plurality of second dummy conductive blocks that are sequentially arranged at intervals in the first direction X.

It is worth noting that, as shown in FIG. 5A, only one second bonding component 21 and one first bonding component 11 are included in the circuit board assembly 100, and the bisecting plane of the first bonding component 11 coincides with the bisecting plane of the first circuit board 1; the second bonding component 21 expands from the bisecting plane to both sides thereof, and the first circuit board 1 also expands from the bisecting plane to both sides thereof; and the expansion ratio of the first circuit board 1 is less than the expansion ratio of the second circuit board 2. Therefore, by preshrinking only the second bonding component 21 or preshrinking both the first bonding component 11 and the second bonding component 21, it may be possible to make the center alignment deviation, in the first direction X, of the second conductive block 211 that is closest to the bisecting plane of the second bonding component 21 and the first conductive block 111 bonded to the second conductive block 211 be less than or equal to 0.01 mm.

It will be noted that, as for the case where the bisecting plane of the first bonding component 11 coincides with the bisecting plane of the first circuit board 1 in which the first bonding component 11 is located, the term "coincident" also includes coincidence within a certain acceptable range of deviation (i.e., approximate coincidence).

As shown in FIG. 5B, only one second bonding component 21 and one first bonding component 11 are included in the circuit board assembly 100, and the bisecting plane of the first bonding component 11 does not coincide with the bisecting plane of the first circuit board 1 in which the first bonding component 11 is located; and the second bonding component 21 expands from the bisecting plane to both sides thereof, and the first circuit board 1 also expands from the bisecting plane to both sides thereof. In this case, by preshrinking each second bonding component 21, and preshrinking the entire first circuit board 1 in the first direction X (i.e., preshrinking all first bonding components 11 of the first circuit board 1), it may be possible to make the center alignment deviation, in the first direction X, of the second conductive block 211 that is closest to the bisecting plane of the second bonding component 21 and the first conductive block 111 bonded to the second conductive block 211 be less than or equal to 0.01 mm.

In some embodiments, the first circuit board 1 includes at least two first bonding components 11 that are sequentially arranged at intervals in the first direction X. At least two second bonding components 21 are included in the at least one second circuit board 2.

The overlapping width, in the first direction X, of each second conductive block 211 in each second bonding component 21 and the first conductive block 111 bonded to the second conductive block 211 is greater than or equal to two thirds of the width of the first conductive block.

Here, by preshrinking each second bonding component 21, and preshrinking the entire first circuit board 1 in the first direction X (i.e., preshrinking all first bonding components 11 of the first circuit board 1), it may be possible to make the overlapping width, in the first direction X, of each second conductive block 211 in each second bonding component 21 and the first conductive block 111 bonded to the second conductive block 211 be greater than or equal to two thirds of the width of the first conductive block.

Based on this, for example, the center alignment deviation, in the first direction X, of the second conductive block 211 in each second bonding component 21 that is closest to the bisecting plane of the second bonding component 21 and the first conductive block 111 bonded to the second conductive block 211 is less than or equal to 0.01 mm.

Here, by preshrinking each second bonding component 21, and preshrinking the entire first circuit board 1 in the first direction X (i.e., preshrinking all first bonding components 11 of the first circuit board 1), it may be possible to make the center alignment deviation, in the first direction X, of the second conductive block 211 in each second bonding component 21 that is closest to the bisecting plane of the second bonding component 21 and the first conductive block 111 bonded to the second conductive block 211 be less than or equal to 0.01 mm.

In some embodiments, with continued reference to FIG. 1, the first circuit board 1 includes three first bonding components 11. The bisecting plane of one of the first bonding components 11 coincides with the bisecting plane of the first circuit board 1, and the other two of the first bonding components 11 are respectively located on two sides of the bisecting plane of the first circuit board 1 in the first direction X. In this case, for example, the number of the second circuit boards 2 is three, and each second circuit board 2 includes one second bonding component 21.

In some embodiments, referring to FIG. 4A, the width d1 of the first conductive block 111 is 0.5 to 0.6 times a center-to-center distance c1 between two adjacent first conductive blocks 111 in the first bonding component 11; and a width d2 of the second conductive block 211 is 0.5 to 0.6 times a center-to-center distance b1 between two adjacent second conductive blocks 211 in the second bonding component 21.

With such a design, it helps increase the contact area of the two conductive blocks in the same group of connection structures (i.e., the first conductive block 111 and the second conductive block 211 connected thereto), so that the failure of electrical connection between the two conductive blocks is not easy to occur.

In some examples, the width d2 of the second conductive block 211 is greater than or equal to two thirds of the width d1 of the first conductive block 111, and less than or equal to five sixths of the width d1 of the first

$$\frac{2}{3}d1 \leq d2 \leq \frac{5}{6}d1$$

conductive block 111. That is, .

With such a design, the width d1 of the first conductive block 111 is greater than the width d2 of the second conductive block 211, which helps the bonding of the second circuit board 2 in which the second conductive block 211 is located to the first circuit board 1.

For example, the center-to-center distance c1 between two adjacent first conductive blocks 111 in the first bonding component 11 is in a range of 0.3 mm to 0.4 mm; and the center-to-center distance b1 between two adjacent second conductive blocks 211 in the second bonding component 21 is in a range of 0.3 mm to 0.4 mm.

Preferably, the center-to-center distance c1 between two adjacent first conductive blocks 111 in the first bonding component 11 may be equal to the center-to-center distance b1 between two adjacent second conductive blocks 211 in the second bonding component 21. In this way, after the first bonding component 11 and the second bonding component 21 are bonded, the two conductive blocks in the same group of connection structures (i.e., the first conductive block 111 and the second conductive block 211 connected thereto) are accurately aligned, which may ameliorate the problem that the short circuit is easy to occur between two conductive blocks that are respectively located in two adjacent groups of connection structures and respectively located in two circuit boards.

In some examples, the width d1 of the first conductive block 111 is in a range of 0.18 mm to 0.28 mm.

In some examples, the width d2 of the second conductive block 211 is in a range of 0.15 mm to 0.2 mm.

In this way, after the first bonding component 11 and the second bonding component 21 are bonded, it is easy to make the two conductive blocks in the same group of connection structures (i.e., the first conductive block 111 and the second conductive block 211 connected thereto) be accurately aligned; moreover, it helps increase the contact area of the two conductive blocks in the same group of connection structures, so that the failure of electrical connection between the two conductive blocks is not easy to occur.

In some embodiments, an expansion ratio, at the unit temperature, of the center-to-center distance between two adjacent second conductive blocks 211 in the second bonding component 21 is 2 to 3 times an expansion ratio, at the unit temperature, of the center-to-center distance between two adjacent first conductive blocks 111 in the first bonding component 11.

It is worth noting that, as for the circuit board assembly 100 provided in the embodiments of the present disclosure, in the case where the expansion ratio, at the unit temperature, of the center-to-center distance between two adjacent second conductive blocks 211 in the second bonding component 21 is 2 to 3 times the expansion ratio, at the unit temperature, of the center-to-center distance between two adjacent first conductive blocks 111 in the first bonding component 11, it can still make the overlapping width a1, in the first direction X, of each second conductive block 211 in the at least one second bonding component 21 and the first conductive block 111 bonded to the second conductive block 211 greater than or equal to two thirds of the width d1 of the first conductive block 111. Based on this, in some examples, for the at least one second bonding component 21, the center alignment deviation, in the first direction, of the second conductive block that is closest to the bisecting plane of the second bonding component and the first conductive block bonded to the second conductive block is less than or equal to 0.01 mm.

In some embodiments, referring to FIG. 2, the first bonding component 11 further includes at least two first alignment structures 112. For example, at least one first alignment structure 112 is disposed at each of two ends of the first bonding component 11. That is, the at least one first alignment structure 112 is disposed at each of two ends of the plurality of first conductive blocks 111 that corresponds to the first bonding component 11. For example, with continued reference to FIG. 2, one first alignment structure 112 is disposed at each of the two ends of the plurality of first conductive blocks 111. In a case where the first circuit board 1 is further provided with the first dummy bonding component 12 therein, the plurality of first conductive blocks 111 are separated from the dummy bonding component 12 through the first alignment structure 112.

Referring to FIG. 3, the second bonding component 21 further includes at least two second alignment structures 212. Optionally, a shape of the second alignment structure 212 corresponds to a shape of the first alignment structure 112, and the number of the second alignment structures 212 corresponds to the number of the first alignment structures 112. A distance between two adjacent first alignment structures 112 (e.g., first alignment structures 112 located at the two ends of the first bonding component 11) is less than a distance between two corresponding adjacent second alignment structures 212.

In some examples, with continued reference to FIG. 3, the second alignment structure 212 is a rectangular structure. The second alignment structure 212 may also be a cross-shaped structure or a circular structure, which is not limited here.

In a case where there is one first alignment structure 112 disposed at each of the two ends of the first bonding component 11, and there is also one second alignment structure 212 disposed at each of the two ends of the second bonding component 21 that corresponds to the first bonding component 11, during the bonding process of the first bonding component 11 and the second bonding component 21, positions of the two adjacent second alignment structures 212 and the two adjacent first alignment structures 112 are captured by using an image capturing device (e.g., a charge-coupled device (CCD) camera), so that the two adjacent second alignment structures 212 and the two adjacent first alignment structures 112 are aligned in one-to-one correspondence (for example, a feature position on a second alignment structure 212 is aligned with a feature position on a corresponding first alignment structure 112); then the first bonding component 11 and the second bonding component 21 are heated to the preset temperature; and finally, the first bonding component 11 and the second bonding component 21 are pressed with the preset pressure intensity. Before the first bonding component 11 and the second bonding component 21 are heated, a distance between two adjacent first bonding components 11 is equal to a distance between two adjacent second bonding components 21. However, after the first bonding component 11 and the second bonding component 21 are heated, since the expansion ratio of the second bonding component 21 is greater than the expansion ratio of the first bonding component 11 at the same conditions, a final distance between the two adjacent first alignment structures 112 is less than a final distance between the two corresponding adjacent second alignment structures 212. In some other embodiments, when the first bonding component 11 and the second bonding component 21 are heated to a preset bonding temperature, the feature position on the second alignment structure 212 may be aligned with the feature position on the corresponding first alignment structure 112, so that the final distance between the two adjacent first alignment structures 112 is equal to or approximately equal to the final distance between the two corresponding adjacent second alignment structures 212.

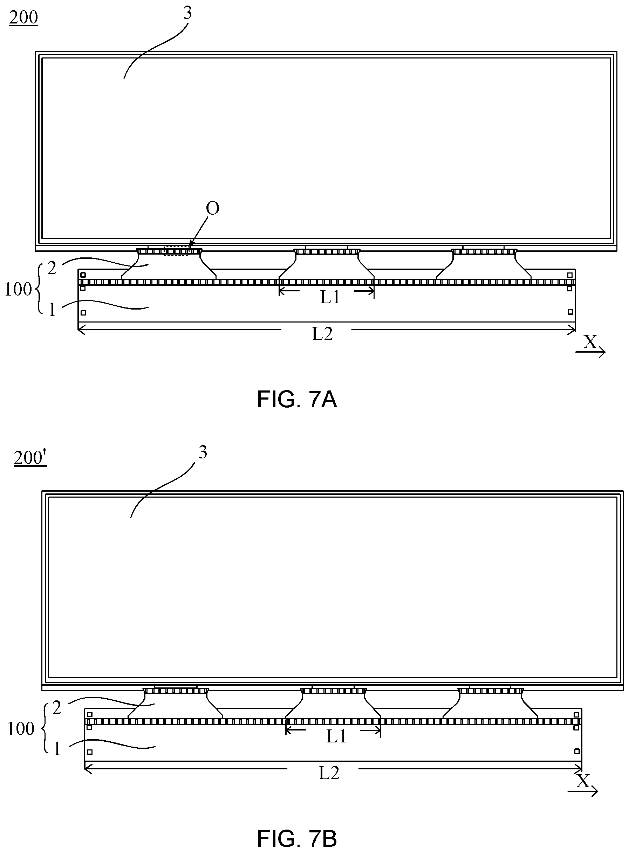

Referring to FIG. 7A, some embodiments of the present disclosure provide a display module 200. The display module 200 includes a display panel 3 and at least one circuit board assembly 100 as described in any one of the above embodiments, all second circuit boards 2 of the circuit board assembly 200 are bonded to a same side of the display panel 3.

Since the display module 200 provided in the embodiments of the present disclosure includes the circuit board assembly 100, the display module 200 has all the beneficial effects of the circuit board assembly 100 described above.

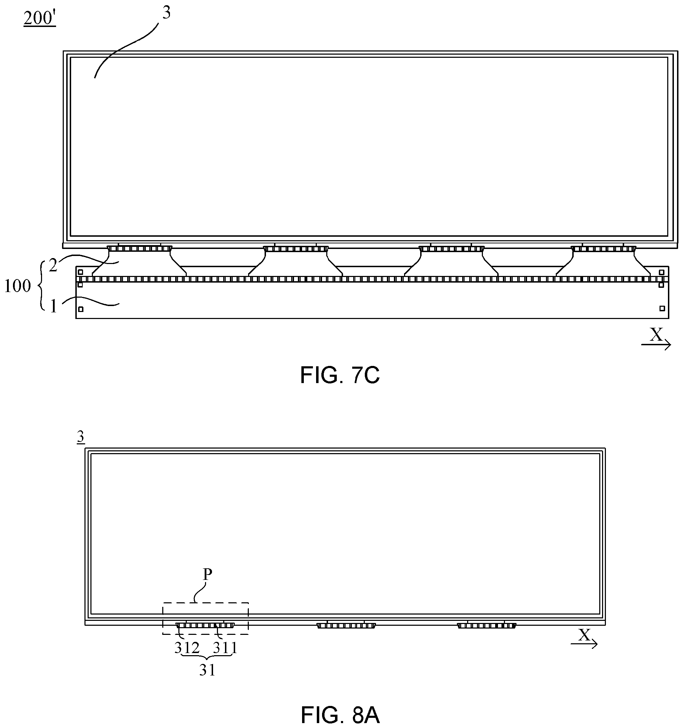

In some embodiments, referring to FIG. 8A, the display panel 3 includes at least one third bonding component 31, and the third bonding component 31 includes a plurality of third conductive blocks 311 that are sequentially arranged at intervals in the first direction X.

Referring to FIG. 3, the at least one second circuit board 2 further includes at least one fourth bonding component 22. For example, each second circuit board 2 includes at least one fourth bonding component 22.

The fourth bonding component 22 includes a plurality of fourth conductive blocks 221 that are sequentially arranged at intervals. The plurality of fourth conductive blocks 221 in the fourth bonding component 22 are bonded to the plurality of third conductive blocks 311 in a third bonding component 31 in one-to-one correspondence.

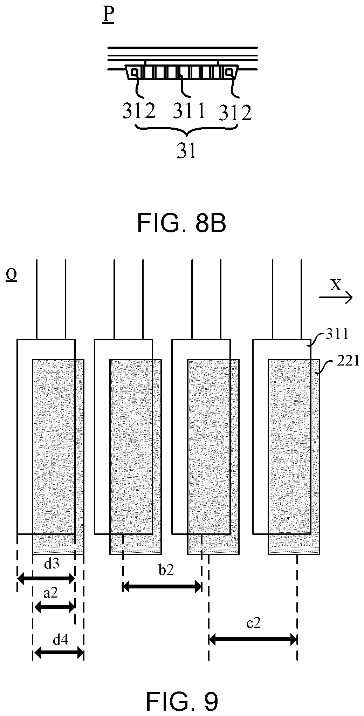

In some examples, referring to FIG. 9, an overlapping width a2, in the first direction X, of each fourth conductive block 221 in the at least one fourth bonding component 22 and a third conductive block 311 bonded to the fourth conductive block 221 is greater than or equal to two thirds of a width d3 of the third conductive block

$$a2 \geq \frac{2}{3}d3$$

311. That is, . In this way, a contact area of two conductive blocks in a same group of connection structures (i.e., the fourth conductive block 221 and the third conductive block 311 connected thereto) may be relatively large, so that a failure of electrical connection between the two conductive blocks is not easy to occur. Moreover, since the two conductive blocks in the same group of connection structures are accurately aligned, it may ameliorate a problem that the short circuit is easy to occur between two conductive blocks that are respectively located in two adjacent groups of connection structures and respectively located in two circuit boards.

In some embodiments, as for at least one fourth bonding component 22 (e.g., all fourth bonding components 22), a center alignment deviation, in the first direction X, of a fourth conductive block 221 that is closest to a bisecting plane of each fourth bonding component 22 and a third conductive block 311 bonded to the fourth conductive block 221 is less than or equal to 0.01 mm.

In some examples, the second circuit board 2 may further include at least one fourth dummy bonding component. As for an arrangement between the at least one fourth dummy bonding component and the at least one fourth bonding component 22, reference may be made to the arrangement between the at least one second dummy bonding component and the at least one second bonding component 21 described above, which will not be repeated here. The center alignment deviation of the fourth conductive block 221 and the third conductive block 311 will not be affected by the arrangement of the fourth dummy bonding component.

In some examples, the expansion ratio of the second circuit board 2 is greater than an expansion ratio of an end of the display panel 3 connected to the second circuit board 2. For example, in the case where the second circuit board 2 is the FPC, the second circuit board 2 expands to a relatively large degree after being heated. Based on this, before the plurality of third conductive blocks 311 in the third bonding component 31 and the plurality of fourth conductive blocks 221 in the fourth bonding component 22 are bonded in the one-to-one correspondence, by reducing a design value of a center-to-center distance between any two adjacent fourth conductive blocks 221 in the fourth bonding component 22, it is possible to make the center alignment deviation, in the first direction X, of the fourth conductive block 221 that is closest to the bisecting plane of the fourth bonding component 22 and the third conductive block 311 bonded to the fourth conductive block 221 less than or equal to 0.01 mm after the third bonding component 31 and the fourth bonding component 22 expand due to heating.

In some embodiments, referring to FIGS. 3, 7A and 8A, the display panel 3 includes at least two third bonding components 31 that are sequentially arranged at intervals in the first direction X. The number of second circuit boards 2 is at least two, and each second circuit board 2 includes one fourth bonding component 22.

For example, with continued reference to FIG. 7A, the display panel 3 includes three third bonding components 31 that are sequentially arranged at intervals in the first direction X, and the number of the second circuit boards 2 is three. The fourth bonding components 22 in the second circuit boards 2 are in one-to-one correspondence with the third bonding components 31 in the display panel 3.

In some embodiments, the width d3 of the third conductive block 311 is 1.1 to 1.3 times a center-to-center distance b2 between two adjacent third conductive blocks 311; and the width d3 of the fourth conductive block 221 is 0.5 times a center-to-center distance c2 between two adjacent fourth conductive blocks 221 in the fourth bonding component 22.

With such a design, it helps increase the contact area of the two conductive blocks in the same group of connection structures (i.e., the third conductive block 311 and the fourth conductive block 221 connected thereto), so that the failure of electrical connection between the two conductive blocks is not easy to occur.

For example, the center-to-center distance b2 between two adjacent third conductive blocks 311 in the third bonding component 31 is in a range of 0.1 mm to 0.3 mm; and the center-to-center distance c2 between two adjacent fourth conductive blocks 221 in the fourth bonding component 22 is in a range of 0.1 mm to 0.3 mm. In this way, after the third bonding component 31 and the fourth bonding component 22 are bonded, the two conductive blocks in the same group of connection structures (i.e., the third conductive block 311 and the fourth conductive block 221 connected thereto) are accurately aligned, which may ameliorate the problem that the short circuit is easy to occur between two conductive blocks that are respectively located in two adjacent groups of connection structures and respectively located in two circuit boards.

In some examples, the width d3 of the third conductive block 311 is in a range of 0.055 mm to 0.195 mm.

In some examples, the width d4 of the fourth conductive block 221 is in a range of 0.05 mm to 0.15 mm.

In this way, after the third bonding component 31 and the fourth bonding component 22 are bonded, it is easy to make the two conductive blocks in the same group of connection structures (i.e., the third conductive block 311 and the fourth conductive block 221 connected thereto) be accurately aligned; moreover, it helps increase the contact area of the two conductive blocks in the same group of connection structures, so that the failure of electrical connection between the two conductive blocks is not easy to occur.

In some embodiments, referring to FIGS. 8A and 8B, the third bonding component 31 further includes at least two third alignment structures 312. Referring to FIG. 2, the fourth bonding component 22 further includes at least two fourth alignment structures 222, and a distance between two adjacent third bonding components 31 is less than a distance between two corresponding adjacent fourth bonding components 22. As for arrangements of the third alignment structures 312 and the fourth alignment structures 222, reference may be made to the arrangements of the first alignment structures 112 and the second alignment structures 212, which will not be repeated here. By arranging the third alignment structures 312 and the fourth alignment structures 222, it may be possible to make the third bonding component 31 and the fourth bonding component 22 be accurately aligned during the alignment and bonding process.

Referring to FIG. 7B and in combination with FIGS. 2 to 4, some embodiments of the present disclosure further provide a display module 200'. The display module 200' includes the display panel 3 and a circuit board assembly 100 located on a side of the display panel 3 and bonded to the display panel 3.

The circuit board assembly 100 includes a first circuit board 1 and a plurality of second circuit boards 2. An expansion ratio of the first circuit board 1 is less than an expansion ratio of the second circuit board 2.

The first circuit board 1 includes a plurality of first bonding components 11, and a first bonding component 11 includes a plurality of first conductive blocks 111 that are sequentially arranged at intervals in the first direction X.

Each second circuit board 2 includes at least one second bonding component 21, and a second bonding component 21 includes a plurality of second conductive blocks 211 that are sequentially arranged at intervals. The plurality of second conductive blocks 211 in the second bonding component 21 are bonded to the plurality of first conductive blocks 111 in the first bonding component 11 in one-to-one correspondence.

Each second conductive block 211 in the second bonding component 21 overlaps with a first conductive block 111 bonded thereto, and a change ratio of an overlapping state, in the first direction X, of a second conductive block 211 corresponding to a middle position of the second bonding component 21 is less than 0.050%.

In some examples, in a case where the number R of the second conductive blocks 211 in the second bonding component 21 is an odd number, the second conductive block 211 corresponding to the middle position of the second bonding component 21 is a second conductive block 211 at the middle position (i.e., at a position of (R + 1) / 2) of the second bonding component 21. In a case where the number R of the second conductive blocks 211 in the second bonding component 21 is an even number, the second conductive block 211 corresponding to the middle position of the second bonding component 21 is a second conductive block 211, which is farthest away from the bisecting plane of the first circuit board 1, in two second conductive blocks 211 at the middle of the second bonding component 21. It can be understood that, in a case where the two second conductive blocks 211 have a same distance to the bisecting plane of the first circuit board 1, one of them can be selected.

Based on this, as for the second conductive block 211 corresponding to the middle position of the second bonding component 21, the change ratio of the overlapping state thereof is calculated, for example, in the following manner.

In the case where the number R of the second conductive blocks 211 in the second bonding component 21 is the odd number, the change ratio of the overlapping state of the second conductive block 211 corresponding to the middle position of the second bonding component 21 in the first direction X may be calculated by two second conductive blocks 211 that are adjacent to the second conductive block 211 located at the middle position. In the case where the number R of the second conductive blocks 211 in the second bonding component 21 is the even number, the change ratio of the overlapping state of the second conductive block 211 corresponding to the middle position of the second bonding component 21 in the first direction X may be calculated by one of two second conductive blocks 211 at the middle, which is closest to the bisecting plane of the second bonding component 21. As for the calculation manners in the above two cases, reference may be made to the change ratio $\rho$ of the overlapping state of the second bonding component 21 in the first direction X in the embodiments described above, which will not be repeated here.

In the related art, the expansion ratio of the first circuit board 1 at the unit temperature is 1 / 437500. In the process where the second circuit board 2 and the first circuit board 1 are bonded, the temperature needs to be increased from the normal temperature (e.g., 25°C) to the preset temperature (e.g., 250°C). In this case, the first circuit board 1 and the second circuit board 2 are both thermally expanded. In addition, during the expansion process of the first circuit board 1 and the second circuit board 2, the positions of their respective bisecting planes remain unchanged. In this case, the change ratio of the overlapping state of the second conductive block 211 corresponding to the middle position of the second bonding component 21 in the first direction X is greater than 0.050%. A calculation manner of the change ratio of the overlapping state may be referred to the following formula:

$$\frac{\dfrac{1}{4375000} \times 225}{1 + \dfrac{1}{437500} \times 225} \approx 0.051\%.$$

As for the display module 200' provided in some embodiments of the present disclosure, in a case where the plurality of second circuit boards 2 are arranged, and the plurality of second circuit boards 2 have been bonded onto the display panel 3, in the process where the second bonding component 21 and the first bonding component 11 are bonded, the position of the second conductive block 211 located at the middle position of the second bonding component 21 does not change. Therefore, the change ratio of the overlapping state, in the first direction X, of the second conductive block 211 corresponding to the middle position of the second bonding component 21 is less than 0.050%. That is, the first circuit board 1 of the display module 200' provided in the present disclosure has been preshrunk. With such a design, the change ratio of the overlapping state of the second bonding component 21 in the first direction X may be less than 0.050%, so that the second conductive block 211 corresponding to the middle position of the second bonding component 21 and the first conductive block 111 corresponding to the second conductive block 211 may be in a good aligned and bonded state. As a result, the bonding yield of the circuit board assembly 100 may be improved.

It will be noted that, in some examples, ideally, the change ratio of the overlapping state may be equal to 0, so that the two conductive blocks bonded to each other can completely overlap with each other. Of course, in general, the change ratio of the overlapping state is not equal to 0 due to the bonding error. For example, the change ratio of the overlapping state is in the range of 0 to 0.050%.

In some embodiments, the change ratio of the overlapping state, in the first direction X, of the second conductive block 211 corresponding to the middle position of the second bonding component 21 is less than 0.039%.

A grade of a material of the first circuit board 1 may be FR-4. The second circuit board 2 may include a polyimide (PI) substrate and a metal wiring layer disposed on the PI substrate. FR-4 is a grade code of a flame-resistant material, and refers to a material specification that a resin material is capable of self-extinguishing after combustion. FR-4 is not a name of a material, but the grade of the material. Therefore, materials of FR-4 grade generally used in the circuit board are of various types, but most of the materials are composite materials made of so-called tetra-functional epoxy resin, filler and fiberglass.

In this case, after the temperature is increased from the normal temperature (25°C) to the temperature that is in the range of 150°C to 250°C, an expansion proportion between two adjacent first conductive blocks 111 in the first bonding component 11 of the first circuit board 1 is about 0.04%, and an expansion proportion between two adjacent second conductive blocks 211 in the second bonding component 21 of the second circuit board 2 is in the range of 0.08% to 0.12%.

Based on this, the change ratio of the overlapping state of the second conductive block 211 corresponding to the middle position of the second bonding component 21 in the first direction X is greater than 0.039%. A calculation manner of the change ratio of the overlapping state may be referred to the following formula:

$$\frac{0.04\%}{(1+0.08\%)} \approx 0.040\%$$

In the display module 200' provided in the embodiments of the present disclosure, since the first circuit board 1 has been preshrunk, the change ratio of the overlapping state of the second conductive block 211 corresponding to the middle position of the second bonding component 21 in the first direction X may be less than 0.039%. Therefore, the second conductive block 211 corresponding to the middle position of the second bonding component 21 and the first conductive block 111 corresponding to the second conductive block 211 may be in the good aligned and bonded state. As a result, the bonding yield of the circuit board assembly 100 may be further improved.

In some embodiments, the change ratio of the overlapping state, in the first direction X, of the second conductive block 211 corresponding to the middle position of the second bonding component 21 is less than 0.028%.

It will be noted that, in some implementations, the expansion ratio of the second circuit board 2 at the unit temperature is about $1/218750$, and the expansion ratio of the first circuit board 1 at the unit temperature is $1/437500$. During the bonding process of the second circuit board 2 and the first circuit board 1, the temperature needs to be increased from the normal temperature (e.g., 25°C) to a preset temperature (e.g., 150°C). In this case, the change ratio of the overlapping state of the second bonding component 21 in the first direction X is greater than 0.028%. A calculation manner of the change ratio of the overlapping state may be referred to the following formula:

$$\frac{\frac{1}{437500} \times 125}{1 + \frac{1}{437500} \times 125} \approx 0.029\%$$

In the circuit board assembly 100 provided in the embodiments of the present disclosure, since the first circuit board 1 has been preshrunk, the change ratio of the overlapping state of the second conductive block 211 corresponding to the middle position of the second bonding component 21 in the first direction X may be less than 0.028%. As a result, the second conductive block 211 corresponding to the middle position of the second bonding component 21 and the first conductive block 111 corresponding to the second conductive block 211 may be in a better aligned and bonded state, and thus the bonding yield of the circuit board assembly 100 may be further improved.

In some embodiments, the change ratio of the overlapping state, in the first direction X, of the second conductive block 211 corresponding to the middle position of the second bonding component 21 is less than 0.014%.

In this case, since the first circuit board 1 of the display module 200' provided in the present disclosure has been preshrunk, the change ratio of the overlapping state of the second conductive block 211 corresponding to the middle position of the second bonding component 21 in the first direction X may be less than 0.014%. As a result, the second conductive block 211 corresponding to the middle position of the second bonding component 21 and the first conductive block 111 corresponding to the second conductive block 211 may be in the good aligned and bonded state, and thus the bonding yield of the circuit board assembly 100 may be improved more effectively.

In some embodiments, the change ratio of the overlapping state, in the first direction X, of the second conductive block 211 corresponding to the middle position of the second bonding component 21 is less than 0.005%.

In this case, since the first circuit board 1 of the display module 200' provided in the present disclosure has been preshrunk, the change ratio of the overlapping state of the second conductive block 211 corresponding to the middle position of the second bonding component 21 in the first direction X may be less than 0.005%. As a result, the second conductive block 211 corresponding to the middle position of the second bonding component 21 and the first conductive block 111 corresponding to the second conductive block 211 may be in a better aligned and bonded state, and thus the bonding yield of the circuit board assembly 100 may be improved more effectively.

In some implementations, a dimension of the first circuit board 1 in the first direction X may be less than or equal to 350 mm, such as in a range of 250 mm to 300 mm; and a dimension L1 of the second circuit board 2 in the first direction X may be less than or equal to 200 mm, such as in a range of 40 mm to 80 mm.

In some embodiments, referring to FIGS. 3 and 7B, the second circuit board 2 includes a first end T2 bonded to the first circuit board 1 and a second end T2 connected to the display panel 3.

In a direction pointing from the bisecting plane of the first circuit board 1 to an edge of the first circuit board 1, as for all the second circuit boards 2, deviations between midpoints M1 of first ends and midpoints M2 of respective second ends in the first direction X gradually increase.

It is worth noting that, the deviation between the midpoint M1 of the first end and the midpoint M2 of the second end in the first direction X is a distance, in the first direction X, between the midpoint M1 of the first end and the midpoint M2 of the second end.

In some examples, referring to FIG. 7C, there are one first circuit board 1 and four second circuit boards 2, and each second circuit board 2 is provided with one second bonding component 21 therein. Since the four second circuit boards 2 have all been bonded onto the display panel 3, positions of midpoints M2 of second ends of the four second circuit boards 2 do not change. In a process where the four second bonding components 21 are respectively bonded to four first bonding components 11 in the first circuit board 1, conductive blocks in all bonding components are aligned and then bonded at the preset temperature (e.g., 150°C to 250°C). Since the first circuit board 1 has been preshrunk, after being heated, all first conductive blocks 111 in the first bonding components 11 are aligned with all second conductive blocks 211 in the second bonding components 21, respectively. After the bonding process is completed, the first circuit board 1 shrinks due to cooling. In this case, the first circuit board 1 will pull the second circuit boards 2 to which the first circuit board 1 is connected to be gathered toward the bisecting plane of the first circuit board 1. In addition, the farther a second circuit board is away from the bisecting plane, the more obvious the contraction of the midpoint M1 of the first end of the second circuit board 2 is. Therefore, in the direction from the bisecting plane of the first circuit board 1 to the edge of the first circuit board 1, as for all the second circuit boards 2, the deviations between the midpoints M2 of the first ends and the midpoints M1 of the respective second ends in the first direction X gradually increase.

In some embodiments, in the same second circuit board 2, the midpoint M2 of the second end is farther away from the bisecting plane of the first circuit board 1 than the midpoint M1 of the first end.

Since the second circuit boards 2 have been bonded onto the display panel 3, the midpoints of the second ends of the second circuit boards 2 are fixed. In the bonding process of the first circuit board 1 and the second circuit boards 2, since the first circuit board 1 has been preshrunk, after being heated, all first conductive blocks 111 in the first bonding components 11 are aligned with all second conductive blocks 211 in the second bonding components 21. After the bonding process is completed, the first circuit board 1 shrinks due to cooling. In this case, the first circuit board 1 will pull the midpoints of the first ends of the second circuit boards 2 to which the first circuit board 1 is connected to be gathered toward the bisecting plane of the first circuit board 1. Therefore, in the same second circuit board 2, the midpoint M1 of the first end is closer to the bisecting plane of the first circuit board 1 than the midpoint M2 of the second end. With such a design, the second conductive block 211 corresponding to the middle position of the second bonding component 21 and the first conductive block 111 corresponding to the second conductive block 211 may be in the good aligned and bonded state, and thus the bonding yield of the circuit board assembly 100 may be improved.

In some embodiments, as for each of all second bonding components 21, the change ratio of the overlapping state, in the first direction X, of the second conductive block 211 close to the bisecting plane of the second bonding component 21 is the same.

It will be noted that, in the second bonding component 21, the second conductive block 211 close to the bisecting plane of the second bonding component 21 is the second conductive block 211 corresponding to the middle position of the second bonding component 21, which will not be repeated here.

Referring to FIG. 7C, the number of the second circuit boards 2 is greater than or equal to three. The position of the bisecting plane of the second bonding component 21 in each second circuit board 2 is relatively unchanged when being heated, and the first circuit board 1 has been preshrunk as a whole. Therefore, when second bonding components 21 in any two second circuit boards 2 are used to measure the change ratio of the overlapping state, the change ratios of the overlapping state, in the first direction X, of second conductive blocks 211 that are close to respective bisecting planes of the second bonding components 21 are the same. Of course, there may also be a slight deviation, and the slight deviation may be caused by bonding error and the conductive block being not exactly located at a center of the bonding component.

In some examples, in two second bonding components 21 located on two sides of the bisecting plane of the first circuit board 1 and having a same distance to the bisecting plane of the first circuit board 1, an absolute value of the change ratio of the overlapping state, in the first direction X, of the second conductive block 211 of each second bonding component 21 that is close to the bisecting plane of the second bonding component 21 is equal.

In some embodiments, referring to FIG. 8A, the display panel 3 includes at least one third bonding component 31. A third bonding component 31 includes a plurality of third conductive blocks 311 that are sequentially arranged at intervals in the first direction X.

Referring to FIG. 3, at least one second circuit board 2 further includes at least one fourth bonding component 22. For example, each second circuit board 2 includes at least one fourth bonding component 22.

A fourth bonding component 22 includes a plurality of fourth conductive blocks 221 that are sequentially arranged at intervals. The plurality of fourth conductive blocks 221 in the fourth bonding component 22 are bonded to the plurality of third conductive blocks 311 in the third bonding component 31 in one-to-one correspondence.

Referring to FIG. 9, an overlapping width a2, in the first direction X, of each fourth conductive block 221 in the at least one fourth bonding component 22 and a third conductive block 311 bonded to the fourth conductive block 221 is greater than or equal to two thirds of a width d3 of the third conductive block 311. That is,

$$a2 \geq \frac{2}{3}d3$$

. In this way, a contact area of two conductive blocks in a same group of connection structures (i.e., the fourth conductive block 221 and the third conductive block 311 connected thereto) may be large, so that a failure of electrical connection between the two conductive blocks is not easy to occur. Moreover, since the two conductive blocks in the same group of connection structures are aligned accurately, it may be possible to ameliorate the problem that the short circuit is easy to occur between two conductive blocks that are respectively located in two adjacent groups of connection structures and respectively located in two circuit boards.

In addition, the third bonding component 31 and the fourth bonding component 22 may also be arranged with reference to the arrangement provided for the display module 200 described above, effects achieved by the both are the same, and will not be repeated here.

In some embodiments, as for one or more second circuit boards 2 in all second circuit boards 2, the overlapping width a1, in the first direction X, of each second conductive block 211 in second bonding component(s) 22 of the second circuit board(s) 2 and the first conductive block 111 bonded to the second conductive block 211 is greater than or equal to two thirds of the width d1 of the first conductive block 111.

With such a design, a contact area of two conductive blocks in a same group of connection structures (i.e., the first conductive block 111 and the second conductive block 211 connected thereto) may be relatively large, so that a failure of electrical connection between the two conductive blocks is not easy to occur. Moreover, since the two conductive blocks in the same group of connection structures are aligned accurately, it may ameliorate a problem that the short circuit is easy to occur between two conductive blocks that are respectively located in two adjacent groups of connection structures and respectively located in two circuit boards.

In some embodiments, in a case where the circuit board assembly 100 includes at least one second circuit board 2, the at least one second circuit board as a whole includes at least two second bonding components 21, and a first circuit board 1 includes at least two first bonding components 11 that are sequentially arranged at intervals in the first direction X, the change ratio of the overlapping state of each of the at least two second bonding components 21 in the first direction X is equal. That is, in the circuit board assembly 100 provided in the present disclosure, the first circuit board 1 and all second circuit boards 2 have been preshrunk. In this way, the change ratio of the overlapping state of each second bonding component 21 in the first direction X is equal, and in this case, a change trend of an overlapping of each second conductive block 211 in the second bonding components 21 and the first conductive block 111 is the same, thereby helping control the bonding yield of the second bonding component 21 and the first bonding component 11, and improving the production yield of the circuit board assembly 100.

In some embodiments, referring to FIGS. 1 and 2, the first circuit board 1 further includes at least one first dummy bonding component 12. In the first direction X, the at least one first dummy bonding component 12 and the at least one first bonding component 11 are arranged side by side, and are alternately arranged from one side of the first circuit board 1 to the other side of the first circuit board 1. The first dummy bonding component 12 includes a plurality of first dummy conductive blocks 122 that are sequentially arranged at intervals in the first direction X.

With such a design, it may be possible to ameliorate a poor bonding caused by a segmental arrangement of the first bonding components 11 in the first circuit board 1. As a result, after the second bonding component 21 is bonded to the first bonding component 11, a pressure on each group of connection structures is uniform, the connection is reliable, and a transmission of an electrical signal is stable.

In some embodiments, a center alignment deviation, in the first direction X, of a second conductive block 211 that is closest to the bisecting plane of the second bonding component 21 and a first conductive block 111 bonded to the second conductive block 211 is less than or equal to 0.01 mm.

In some embodiments, referring to FIG. 4A, the width d1 of the first conductive block 111 is 0.5 to 0.6 times a center-to-center distance c1 between two adjacent first conductive blocks 111 in the first bonding component 11; and a width d2 of the second conductive block 211 is 0.5 to 0.6 times a center-to-center distance b1 between two adjacent second conductive blocks 211 in the second bonding component 21.

With such a design, it helps increase the contact area of the two conductive blocks in the same group of connection structures (i.e., the first conductive block 111 and the second conductive block 211 connected thereto), so that the failure of electrical connection between the two conductive blocks is not easy to occur.

In some examples, the width d2 of the second conductive block 211 is greater than or equal to two thirds of the width d1 of the first conductive block 111, and less than or equal to five sixths of the width d1 of the first conductive block 111. That is,

$$\frac{2}{3}d1 \le d2 \le \frac{5}{6}d1.$$

With such a design, the width d1 of the first conductive block 111 is greater than the width d2 of the second conductive block 211, which helps the bonding of the second circuit board 2 in which the second conductive block 211 is located to the first circuit board 1.

For example, the center-to-center distance c1 between two adjacent first conductive blocks 111 in the first bonding component 11 is in a range of 0.3 mm to 0.4 mm; and the center-to-center distance b1 between two adjacent second conductive blocks 211 in the second bonding component 21 is in a range of 0.3 mm to 0.4 mm.

Preferably, the center-to-center distance c1 between two adjacent first conductive blocks 111 in the first bonding component 11 may be equal to the center-to-center distance b1 between two adjacent second conductive blocks 211 in the second bonding component 21.

In this way, after the first bonding component 11 and the second bonding component 21 are bonded, the two conductive blocks in the same group of connection structures (i.e., the first conductive block 111 and the second conductive block 211 connected thereto) are accurately aligned, which may ameliorate the problem that the short circuit is easy to occur between two conductive blocks that are respectively located in two adjacent groups of connection structures and respectively located in two circuit boards.

In some examples, the width d1 of the first conductive block 111 is in a range of 0.18 mm to 0.28 mm.

In some examples, the width d2 of the second conductive block 211 is in a range of 0.15 mm to 0.2 mm.

In this way, after the first bonding component 11 and the second bonding component 21 are bonded, it is easy to make the two conductive blocks in the same group of connection structures (i.e., the first conductive block 111 and the second conductive block 211 connected thereto) be accurately aligned; moreover, it helps increase the contact area of the two conductive blocks in the same group of connection structures, so that the failure of electrical connection between the two conductive blocks is not easy to occur.

In some embodiments, an expansion ratio, at a unit temperature, of the center-to-center distance between the two adjacent second conductive blocks 211 in the second bonding component 21 is 2 to 3 times an expansion ratio, at the unit temperature, of the center-to-center distance between the two adjacent first conductive blocks 111 in the first bonding component 11.

In some embodiments, referring to FIG. 2, the first bonding component 11 further includes at least two first alignment structures 112. Referring to FIG. 3, the second bonding component 21 further includes at least two second alignment structures 212. A single first alignment structure 112 cooperates with a single second alignment structure 212. Optionally, a shape of the second alignment structure 212 corresponds to a shape of the first alignment structure 112, and the number of the second alignment structures 212 corresponds to the number of the first alignment structures 112.

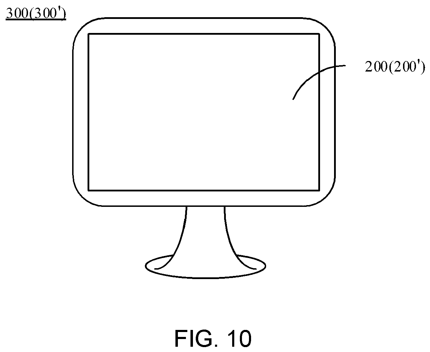

Referring to FIG. 10, some embodiments of the present disclosure provide a display apparatus 300. The display apparatus 300 includes the display module 200 provided in any one of the above embodiments.

Since the display apparatus 300 provided in the embodiments of the present disclosure includes the display module 200, the display apparatus 300 has all the beneficial effects of the display module 200 described above.

For example, the display module 200 includes the circuit board assembly 100. The circuit board assembly 100 includes the first circuit board 1 and the at least one second circuit board 2. The expansion ratio of the first circuit board 1 is less than the expansion ratio of the second circuit board 2. The first circuit board 1 includes at least one first bonding component 11, and the first bonding component 11 includes the plurality of first conductive blocks 111 that are sequentially arranged at intervals in the first direction X. Referring to FIG. 3, the second circuit board 2 includes at least one second bonding component 21, and the second bonding component 21 includes the plurality of second conductive blocks 211 that are sequentially arranged at intervals. The plurality of second conductive blocks 211 in the second bonding component 21 are bonded to the plurality of first conductive blocks 111 in the first bonding component 11 in one-to-one correspondence.

Each second conductive block 211 in the same second bonding component 21 overlaps with the first conductive block 111 bonded thereto, and the change ratio of the overlapping state of the second bonding component 21 in the first direction X is less than 0.102%. The definition and measurement manner of the change ratio of the overlapping state may refer to the above description, which will not be repeated here.

In the circuit board assembly 100, the change ratio of the overlapping state of the second bonding component 21 in the first direction X is less than 0.102%. That is, the second bonding component 21 in the circuit board assembly 100 provided in the present disclosure has been preshrunk. That is, both the second bonding component 21 and the first bonding component 11 in the circuit board assembly 100 provided in the present disclosure have been preshrunk. With such a design, the change ratio of the overlapping state of the second bonding component 21 in the first direction X may be less than 0.102%, so that two conductive blocks in each group of connection structures may be in a good aligned and bonded state, and thus a bonding yield of the circuit board assembly 100 may be improved.

In some embodiments, the change ratio of the overlapping state of the second bonding component 21 in the first direction X is less than 0.059%. The definition and measurement manner of the change ratio of the overlapping state may refer to the above description, which will not be repeated here.

In the circuit board assembly 100 provided in the embodiments of the present disclosure, since at least one circuit board has been preshrunk, the change ratio of the overlapping state of the second bonding component 21 in the first direction X may be less than 0.059%. As a result, the two conductive blocks in each group of connection structures may be in the good aligned and bonded state, and thus the bonding yield of the circuit board assembly 100 may be further improved.

In some embodiments, the change ratio of the overlapping state of the second bonding component 21 in the first direction X is less than 0.039%. The definition and measurement manner of the change ratio of the overlapping state may refer to the above description, which will not be repeated here.

In the circuit board assembly 100 provided in the embodiments of the present disclosure, since at least one circuit board has been preshrunk, the change ratio of the overlapping state of the second bonding component 21 in the first direction X may be less than 0.039%. As a result, the two conductive blocks in each group of connection structures may be in a better aligned and bonded state, and thus the bonding yield of the circuit board assembly 100 may be further improved.

In some embodiments, the change ratio of the overlapping state of the second bonding component 21 in the first direction X is less than 0.028%. The definition and measurement manner of the change ratio of the overlapping state may refer to the above description, which will not be repeated here.

In the circuit board assembly 100 provided in the embodiments of the present disclosure, since at least one circuit board has been preshrunk, the change ratio of the overlapping state of the second bonding component 21 in the first direction X may be less than 0.028%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.014%. The definition and measurement manner of the change ratio of the overlapping state may refer to the above description, which will not be repeated here.

In this case, since the circuit board assembly 100 provided in the present disclosure has been preshrunk, the change ratio of the overlapping state of the second bonding component 21 in the first direction X may be less than 0.014%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.005%. The definition and measurement manner of the change ratio of the overlapping state may refer to the above description, which will not be repeated here.

In this case, since the circuit board assembly 100 provided in the present disclosure has been preshrunk, the change ratio of the overlapping state of the second bonding component 21 in the first direction X may be less than 0.005%. As a result, the two conductive blocks in each group of connection structures may be in the good aligned and bonded state, and thus the bonding yield of the circuit board assembly 100 may be improved more effectively.

With continued reference to FIG. 10, some embodiments of the present disclosure provide a display apparatus 300', and the display apparatus 300' includes the display module 200' described in any one of the above embodiments.

The circuit board assembly 100 included in the display module 200' includes the first circuit board 1 and the plurality of second circuit boards 2. The expansion ratio of the first circuit board 1 is less than the expansion ratio of the second circuit board 2.

The first circuit board 1 includes the plurality of first bonding components 11, and the first bonding component 11 includes the plurality of first conductive blocks 111 that are sequentially arranged at intervals in the first direction X.

Each second circuit board 2 includes at least one second bonding component 21, and the second bonding component 21 includes the plurality of second conductive blocks 211 that are sequentially arranged at intervals. The plurality of second conductive blocks 211 in the second bonding component 21 are bonded to the plurality of first conductive blocks 111 in the first bonding component 11 in one-to-one correspondence.

Each second conductive block 211 in the second bonding component 21 overlaps with the first conductive block 111 bonded the second conductive block 211, and the change ratio of the overlapping state, in the first direction X, of the second conductive block 211 corresponding to the middle position of the second bonding component 21 is less than 0.050%.

In this example, the plurality of second circuit boards 2 are arranged, and the plurality of second circuit boards 2 have been bonded onto the display panel 3. In this case, in the process where the second bonding component 21 and the first bonding component 11 are bonded, the position of the second conductive block 211 located at the middle position of the second bonding component 21 does not changed. Therefore, the change ratio of the overlapping state, in the first direction X, of the second conductive block 211 corresponding to the middle position of the second bonding component 21 is less than 0.050%. That is, the first circuit board 1 of the display module 200' provided in the present disclosure has been preshrunk. With such a design, the change ratio of the overlapping state of the second bonding component 21 in the first direction X may be less than 0.050%, so that the second conductive block 211 corresponding to the middle position of the second bonding component 21 and the first conductive block 111 corresponding to the second conductive block 211 may be in the good aligned and bonded state. As a result, the bonding yield of the circuit board assembly 100 may be improved.

In some embodiments, the change ratio of the overlapping state, in the first direction X, of the second conductive block 211 corresponding to the middle position of the second bonding component 21 is less than 0.039%. The definition and measurement manner of the change ratio of the overlapping state may refer to the above description, which will not be repeated here.

As for the display module 200' provided in the embodiments of the present disclosure, since the first circuit board 1 has been preshrunk, the change ratio of the overlapping state of the second conductive block 211 corresponding to the middle position of the second bonding component 21 in the first direction X may be less than 0.039%. As a result, the second conductive block 211 corresponding to the middle position of the second bonding component 21 and the first conductive block 111 corresponding to the second conductive block 211 may be in the good aligned and bonded state, and thus the bonding yield of the circuit board assembly 100 may be further improved.

In some embodiments, the change ratio of the overlapping state, in the first direction X, of the second conductive block 211 corresponding to the middle position of the second bonding component 21 is less than 0.028%. The definition and measurement manner of the change ratio of the overlapping state may refer to the above description, which will not be repeated here.

As for the circuit board assembly 100 provided in the embodiments of the present disclosure, since the first circuit board 1 has been preshrunk, the change ratio of the overlapping state of the second conductive block 211 corresponding to the middle position of the second bonding component 21 in the first direction X may be less than 0.028%. As a result, the second conductive block 211 corresponding to the middle position of the second bonding component 21 and the first conductive block 111 corresponding to the second conductive block 211 may be in a better aligned and bonded state, and thus the bonding yield of the circuit board assembly 100 may be further improved.

In some embodiments, the change ratio of the overlapping state, in the first direction X, of the second conductive block 211 corresponding to the middle position of the second bonding component 21 is less than 0.014%. The definition and measurement manner of the change ratio of the overlapping state may refer to the above description, which will not be repeated here.

In this case, since the first circuit board 1 of the display module 200' provided in the present disclosure has been preshrunk, the change ratio of the overlapping state of the second conductive block 211 corresponding to the middle position of the second bonding component 21 in the first direction X may be less than 0.014%. As a result, the second conductive block 211 corresponding to the middle position of the second bonding component 21 and the first conductive block 111 corresponding to the second conductive block 211 may be in the good aligned and bonded state, and thus the bonding yield of the circuit board assembly 100 may be improved more effectively.

In some embodiments, the change ratio of the overlapping state, in the first direction X, of the second conductive block 211 corresponding to the middle position of the second bonding component 21 is less than 0.005%. The definition and measurement manner of the change ratio of the overlapping state may refer to the above description, which will not be repeated here.

In this case, since the first circuit board 1 of the display module 200' provided in the present disclosure has been preshrunk, the change ratio of the overlapping state of the second conductive block 211 corresponding to the middle position of the second bonding component 21 in the first direction X may be less than 0.005%. As a result, the second conductive block 211 corresponding to the middle position of the second bonding component 21 and the first conductive block 111 corresponding to the second conductive block 211 may be in a better aligned and bonded state, and thus the bonding yield of the circuit board assembly 100 may be improved more effectively.

In some embodiments, each second conductive block 211 in the same second bonding component 21 overlaps with the first conductive block 111 bonded thereto, and the change ratio of the overlapping state of the second bonding component 21 in the first direction X is less than 0.102%. The definition and measurement manner of the change ratio of the overlapping state may refer to the above description, which will not be repeated here.

In the circuit board assembly 100, the change ratio of the overlapping state of the second bonding component 21 in the first direction X is less than 0.102%. That is, the second bonding component 21 in the circuit board assembly 100 provided in the present disclosure has been preshrunk. That is, both the second bonding component 21 and the first bonding component 11 in the circuit board assembly 100 provided in the present disclosure have been preshrunk. With such a design, the change ratio of the overlapping state of the second bonding component 21 in the first direction X may be less than 0.102%, so that two conductive blocks in each group of connection structures may be in the good aligned and bonded state, and thus the bonding yield of the circuit board assembly 100 may be improved.

In some embodiments, the change ratio of the overlapping state of the second bonding component 21 in the first direction X is less than 0.059%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.059%. As a result, the two conductive blocks in each group of connection structures may be in the good aligned and bonded state, and thus the bonding yield of the circuit board assembly 100 may be further improved.

In some embodiments, the change ratio of the overlapping state of the second bonding component 21 in the first direction X is less than 0.039%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.039%.

As a result, the two conductive blocks in each group of connection structures may be in a better aligned and bonded state, and thus the bonding yield of the circuit board assembly 100 may be further improved.

In some embodiments, the change ratio of the overlapping state of the second bonding component 21 in the first direction X is less than 0.028%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.028%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.014%. The definition and measurement manner of the change ratio of the overlapping state may refer to the above description, which will not be repeated here.

In this case, the circuit board assembly 100 provided in the present disclosure has been preshrunk, and the change ratio of the overlapping state of the second bonding component 21 in the first direction X may be less than 0.014%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.005%. The definition and measurement manner of the change ratio of the overlapping state may refer to the above description, which will not be repeated here.

In this case, the circuit board assembly 100 provided in the present disclosure has been preshrunk, and the change ratio of the overlapping state of the second bonding component 21 in the first direction X may be less than 0.005%. As a result, the two conductive blocks in each group of connection structures may be in the good aligned and bonded state, and thus the bonding yield of the circuit board assembly 100 may be improved more effectively.

Since the display apparatus 300' provided in the embodiments of the present disclosure includes the display module 200', the display apparatus 300' has all the beneficial effects of the display module 200' described above.

The display apparatus 300 (or the display apparatus 300') may be any apparatus that displays images whether in motion (e.g., videos) or stationary (e.g., static images), and whether literal or graphical. The display apparatus 300 (or the display apparatus 300') may include a mobile phone, a wireless apparatus, a personal data assistant (PDA), a hand-held or portable computer, a global positioning system (GPS) receiver/navigator, a camera, an MP3 video player, a video camera, a game console, a watch, a clock, a calculator, a television monitor, a flat panel display, a computer monitor, an automobile display (e.g., an odometer display), a navigator, a cockpit controller and/or cockpit display, a camera view display (e.g., a rear-view camera display in a vehicle), an electronic photo, an electronic billboard or sign, a projector, an architectural structure, and a packaging or aesthetic structure (e.g., a display for displaying an image of a piece of jewelry).

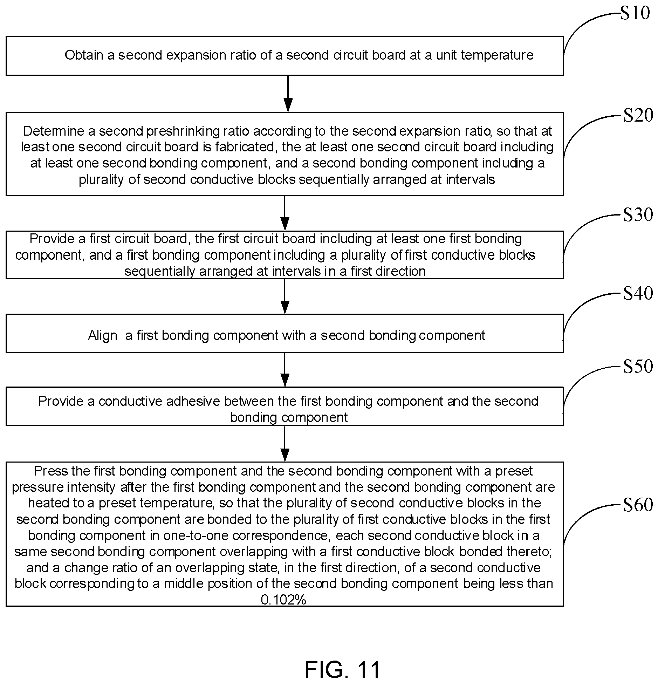

Referring to FIG. 11, some embodiments of the present disclosure provide a method for manufacturing a display module 200. The manufacturing method includes steps S10 to S60.

In S10, a second expansion ratio of a second circuit board 2 at a unit temperature is obtained.

In S20, a second preshrinking ratio is determined according to the second expansion ratio, so that at least one second circuit board 2 is fabricated. The at least one second circuit board 2 includes at least one second bonding component 21, and the second bonding component 21 includes a plurality of second conductive blocks 211 that are sequentially arranged at intervals.

In this step, the second preshrinking ratio may be a product of the second expansion ratio of the second circuit board 2 at the unit temperature and a temperature difference. The temperature difference is a difference between a preset temperature and a normal temperature.

A length of the second bonding component 21 after being preshrunk is equal to a length of the second bonding component 21 before being preshrunk multiplied by a difference between 1 and the second preshrinking ratio.

In S30, a first circuit board 1 is provided. The first circuit board 1 includes at least one first bonding component 11, and the first bonding component 11 includes a plurality of first conductive blocks 111 that are sequentially arranged at intervals in the first direction X.

In S40, a first bonding component 11 is aligned with a second bonding component 21.

In S50, a conductive adhesive is provided between the first bonding component 11 and the second bonding component 21.

In S60, the first bonding component 11 and the second bonding component 21 are pressed with a preset pressure intensity after the first bonding component 11 and the second bonding component 21 are heated to the preset temperature, so that the plurality of second conductive blocks 211 in the second bonding component 21 are bonded to the plurality of first conductive blocks 111 in the first bonding component 11 in one-to-one correspondence. Each second conductive block 211 in a same second bonding component 21 overlaps with a first conductive block 111 bonded thereto, and a change ratio of an overlapping state, in the first direction X, of a second conductive block 211 corresponding to the middle position of the second bonding component 21 is less than 0.102%.

As for the display module 200 manufactured by the manufacturing method provided in the embodiments of the present disclosure, since the bonding component 21 has been preshrunk (for example, in a case where one first circuit board and one second circuit board are included in the display module 200, and the bisecting plane of the first circuit board coincides with the bisecting plane of the second circuit board, at least the second bonding component 21 in the second circuit board with a relatively large expansion ratio has been preshrunk; and as another example, in a case where one first circuit board and at least two second circuit boards are included in the display module 200, and the bisecting plane of at least one second circuit board does not coincide with the bisecting plane of the first circuit board, each second bonding component 21 in the at least one second circuit board and the first bonding component 11 in the first circuit board has been preshrunk), the change ratio of the overlapping state of the second bonding component 21 in the first direction X may be less than 0.102%. As a result, the two conductive blocks in each group of connection structures may be in a good aligned and bonded state, and thus a bonding yield of the first circuit board 1 and the second circuit board 2 may be improved.

In some embodiments, the change ratio of the overlapping state of the second bonding component 21 in the first direction X is less than 0.059%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.059%. As a result, the two conductive blocks in each group of connection structures may be in the good aligned and bonded state, and thus the bonding yield of the circuit board assembly 100 may be further improved.

In some embodiments, providing the first circuit board 1 in S30 includes S301 and S302.

In S301, a first expansion ratio of the first circuit board 1 at a unit temperature is obtained.

In S302, a first preshrinking ratio is determined according to the first expansion ratio, so that the first circuit board 1 is fabricated.

In this step, the first preshrinking ratio may be a product of the first expansion ratio of the first circuit board 1 at the unit temperature and the temperature difference, and the temperature difference is the difference between the preset temperature and the normal temperature.

A length of the first bonding component 11 after being preshrunk is equal to a length of the first bonding component 11 before being preshrunk multiplied by a difference between 1 and the first preshrinking ratio.

In embodiments, the change ratio of the overlapping state of the second bonding component 21 in the first direction X is less than 0.039%.

A grade of a material of the first circuit board 1 is FR-4. The second circuit board 2 includes a polyimide (PI) substrate and a metal wiring layer disposed on the PI substrate. FR-4 is a grade code of a flame-resistant material, and refers to a material specification that a resin material is capable of self-extinguishing after combustion. FR-4 is not a name of a material, but the grade of the material. Therefore, materials of FR-4 grade generally used in the circuit board are of various types, but most of the materials are composite materials made of so-called tetra-functional epoxy resin, filler and fiberglass.

In this case, after the temperature is increased from the normal temperature (25°C) to a temperature that is in a range of 150°C to 250°C, an expansion proportion between two adjacent first conductive blocks 111 in the first bonding component 11 of the first circuit board 1 is about 0.04%; and an expansion proportion between two adjacent second conductive blocks 211 in the second bonding component 21 of the second circuit board 2 is in a range of 0.08% to 0.12%.

Based on the above examples, the expansion proportions each are divided by a temperature change value (e.g., 175°C), and thus it may be obtained that the expansion ratio of the first circuit board 1 at the unit temperature is 1 / 437500, and the expansion ratio of the second circuit board 2 at the unit temperature is 1 / 218750.

It can be seen from the above content that, the change ratio of the overlapping state of the second bonding component 21 in the first direction X is greater than 0.039%. A calculation manner of the change ratio of the overlapping state may be referred to the following formula:

$$\frac{0.08\% - 0.04\%}{(1+0.08\%)} \approx 0.040\%$$

As for the display module 200 manufactured by the embodiments of the present disclosure, since at least one circuit board has been preshrunk, the change ratio of the overlapping state of the second bonding component 21 in the first direction X may be less than 0.039%. As a result, the two conductive blocks in each group of connection structures may be in a better aligned and bonded state, and thus the bonding yield between the first circuit board 1 and the second circuit board 2 may be further improved.

In some embodiments, the change ratio of the overlapping state of the second bonding component 21 in the first direction X is less than 0.028%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.028%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.014%. The definition and measurement manner of the change ratio of the overlapping state may refer to the above description, which will not be repeated here.

In this case, since the circuit board assembly 100 provided in the present disclosure has been preshrunk, the change ratio of the overlapping state of the second bonding component 21 in the first direction X may be less than 0.014%. As a result, the two conductive blocks in each group of connection structures may be in the good aligned and bonded state, and thus the bonding yield of the circuit board assembly 100 may be more effectively.

In some embodiments, the change ratio of the overlapping state of the second bonding component 21 in the first direction X is less than 0.005%. The definition and measurement manner of the change ratio of the overlapping state may refer to the above description, which will not be repeated here.

In this case, since the circuit board assembly 100 provided in the present disclosure has been preshrunk, the change ratio of the overlapping state of the second bonding component 21 in the first direction X may be less than 0.005%. As a result, the two conductive blocks in each group of connection structures may be in the good aligned and bonded state, and thus the bonding yield of the circuit board assembly 100 may be improved more effectively.

In some embodiments, aligning the first bonding component 11 with the second bonding component 21 in S40 includes S401.

In S401, the bisecting plane of the second bonding component 21 is made coincided with the bisecting plane of the first bonding component 11.

In this way, by means of center alignment, the second conductive blocks 211 in the second bonding component 21 and the first conductive blocks 111 in the first bonding component 11 may be aligned well, and thus it helps ensure the bonding yield of the first circuit board 1 and the second circuit board 2.

In some embodiments, the first bonding component 11 further includes at least two first alignment structures 112, and the second bonding component 21 further includes at least two second alignment structures 212.

Based on this, aligning the first bonding component 11 with the second bonding component 21 in S40 includes S402.

In S402, the at least two second alignment structures 212 in the second bonding component 21 are aligned with the at least two first alignment structures 112 in the first bonding component 11, respectively.

In this way, by using alignment marks for alignment, the second conductive blocks 211 in the second bonding component 21 and the first conductive blocks 111 in the first bonding component 11 may be aligned well, and thus it helps ensure the bonding yield of the first circuit board 1 and the second circuit board 2.

In some embodiments, the preset pressure intensity is in a range of 0.1 MPa to 0.4 MPa. In this way, a good pressing effect may be achieved, and thus it helps improve the bonding yield.

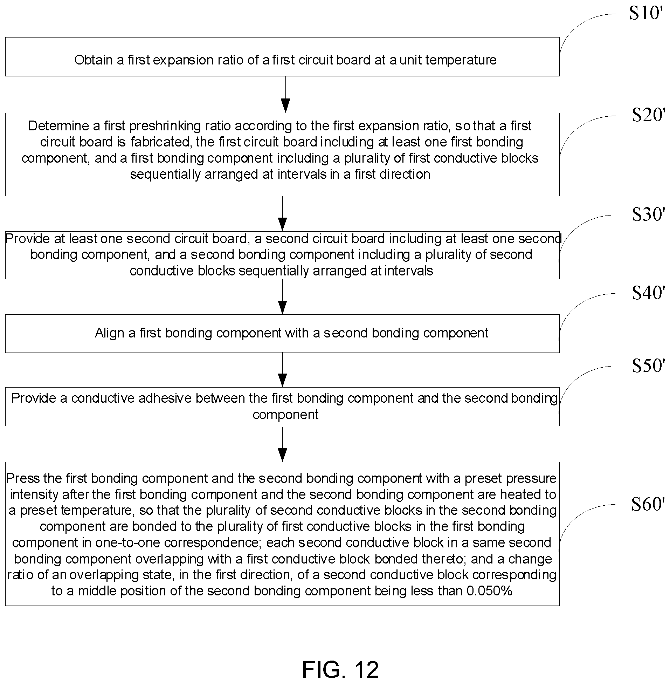

Referring to FIG. 12, some embodiments of the present disclosure provide a method for manufacturing a display module 200'. The manufacturing method includes S10' to S60'.

In S10', a first expansion ratio of a first circuit board 1 at a unit temperature is obtained.

In S20', a first preshrinking ratio is determined according to the first expansion ratio, so that a first circuit board 1 is fabricated. The first circuit board 1 includes at least one first bonding component 11, and a first bonding component 11 includes a plurality of first conductive blocks 111 that are sequentially arranged at intervals in the first direction X.

In this step, the first preshrinking ratio may be a product of the first expansion ratio of the first circuit board 1 at the unit temperature and a temperature difference, and the temperature difference is a difference between a preset temperature and a normal temperature.

A length of the first bonding component 11 after being preshrunk is equal to a length of the first bonding component 11 before being preshrunk multiplied by a difference between 1 and the first preshrinking ratio.

In S30', at least one second circuit board 2 is provided. The at least one second circuit board 2 includes at least one second bonding component 21, and the second bonding component 21 includes a plurality of second conductive blocks 211 that are sequentially arranged at intervals.

In S40', a first bonding component 11 is aligned with a second bonding component 21.

In S50', a conductive adhesive is provided between the first bonding component 11 and the second bonding component 21.

In S60', the first bonding component 11 and the second bonding component 21 are pressed with a preset pressure intensity after the first bonding component 11 and the second bonding component 21 are heated to the preset temperature, so that the plurality of second conductive blocks 211 in the second bonding component 21 are bonded to the plurality of first conductive blocks 111 in the first bonding component 11 in one-to-one correspondence. Each second conductive block 211 in a same second bonding component 21 overlaps with a first conductive block 111 bonded thereto, and a change ratio of an overlapping state, in the first direction X, of a second conductive block 211 corresponding to the middle position of the second bonding component 21 is less than 0.050%.

As for the display module 200' manufactured by the manufacturing method provided in the embodiments of the present disclosure, the first circuit board 1 has been preshrunk. With such a design, the change ratio of the overlapping state of the second bonding component 21 in the first direction X may be less than 0.050%. As a result, the second conductive block 211 corresponding to the middle position of the second bonding component 21 and the first conductive block 111 corresponding to the second conductive block 211 may be in a good aligned and bonded state, and thus a bonding yield of the first circuit board 1 and the second circuit board 2 may be effectively improved.

In some embodiments, the preset pressure intensity is in a range of 0.1 MPa to 0.4 MPa, inclusive. In this way, a good pressing effect may be achieved, and thus it helps improve the bonding yield of the first bonding component 11 and the second bonding component 21.

In some embodiments, at least one second circuit board 2 includes at least one fourth bonding component 22, and the fourth bonding component 22 includes a plurality of fourth conductive blocks 221 that are sequentially arranged at intervals.

Before aligning the first bonding component 11 with the second bonding component 21 in S40', the manufacturing method further includes S301' to S304'.

In S311', a display panel 3 is provided, the display panel 3 includes at least one third bonding component 31, and the third bonding component 31 includes a plurality of third conductive blocks 311 that are sequentially arranged at intervals in the first direction X.

In S312', a third bonding component 31 is aligned with a fourth bonding component 22.

In S313', a conductive adhesive is provided between the third bonding component 31 and the fourth bonding component 22.

In S314', the third bonding component 31 and the fourth bonding component 22 are pressed with a preset pressure after the third bonding component 31 and the fourth bonding component 22 are heated to a preset temperature, so that the plurality of fourth conductive blocks 221 in the fourth bonding component 22 are bonded to the plurality of third conductive blocks 311 in the third bonding component 31 in one-to-one correspondence. An overlapping width, in the first direction X, of each fourth conductive block 221 in the at least one fourth bonding component 22 and a third conductive block 311 bonded to the fourth conductive block 221 is greater than or equal to two thirds of a width of the third conductive block 31.

With such an arrangement, the overlapping width, in the first direction X, of the third conductive block 311 and the fourth conductive block 221 after being aligned and then bonded may be well ensured to be greater than or equal to two thirds of the width of the third conductive block 311, so that a failure of electrical connection between the two conductive blocks is not easy to occur. Moreover, since the two conductive blocks in the same group of connection structures are accurately aligned, it may ameliorate a problem that the short circuit is easy to occur between two conductive blocks that are respectively located in two adjacent groups of connection structures and respectively located in two circuit boards.

In summary, as for the display module 200' manufactured by the manufacturing method provided in the embodiments of the present disclosure, the plurality of second circuit boards 2 are arranged, and the plurality of second circuit boards 2 have been bonded onto the display panel 3. In this case, in the process where the second bonding component 21 and the first bonding component 11 are bonded, the position of the second conductive block 211 located at the middle position of the second bonding component 21 does not change. Therefore, the change ratio of the overlapping state, in the first direction X, of the second conductive block 211 corresponding to the middle position of the second bonding component 21 is less than 0.050%. That is, the first circuit board 1 in the display module 200' provided in the present disclosure has been preshrunk. With such a design, the change ratio of the overlapping state of the second bonding component 21 in the first direction X may be less than 0.050%, so that the second conductive block 211 corresponding to the middle position of the second bonding component 21 and the first conductive block 111 corresponding to the second conductive block 211 may be in the good aligned and bonded state, and thus the bonding yield of first circuit board 1 and the second circuit board 2 may be improved.

In some embodiments, the preset temperature is in a range of 150°C to 250°C, and the preset pressure is in a range of 20 N to 40 N. In this way, a good pressing effect may be achieved, and thus it helps improve the bonding yield of the third bonding component 31 and the fourth bonding component 22.

In some embodiments, the change ratio of the overlapping state, in the first direction X, of the second conductive block 211 corresponding to the middle position of the second bonding component 21 is less than 0.039%.

As for the display module 200' manufactured by the manufacturing method provided in the embodiments of the present disclosure, since the first circuit board 1 has been preshrunk, the change ratio of the overlapping state, in the first direction X, of the second conductive block 211 corresponding to the middle position of the second bonding component 21 may be less than 0.039%. As a result, the second conductive block 211 corresponding to the middle position of the second bonding component 21 and the first conductive block 111 corresponding to the second conductive block 211 may be in the good aligned and bonded state, and thus the bonding yield of the first circuit board 1 and the second circuit board 2 may be further improved.

In some embodiments, the change ratio of the overlapping state, in the first direction X, of the second conductive block 211 corresponding to the middle position of the second bonding component 21 is less than 0.028%. The definition and measurement manner of the change ratio of the overlapping state may refer to the above description, which will not be repeated here.

As for the circuit board assembly 100 provided in the embodiments of the present disclosure, since the first circuit board 1 has been preshrunk, the change ratio of the overlapping state, in the first direction X, of the second conductive block 211 corresponding to the middle position of the second bonding component 21 may be less than 0.028%. As a result, the second conductive block 211 corresponding to the middle position of the second bonding component 21 and the first conductive block 111 corresponding to the second conductive block 211 may be in the good aligned and bonded state, and thus the bonding yield of the circuit board assembly 100 may be further improved.

In some embodiments, the change ratio of the overlapping state, in the first direction X, of the second conductive block 211 corresponding to the middle position of the second bonding component 21 is less than 0.014%. The definition and measurement manner of the change ratio of the overlapping state may refer to the above description, which will not be repeated here.

In this case, since the first circuit board 1 in the display module 200' provided in the present disclosure has been preshrunk, the change ratio of the overlapping state, in the first direction X, of the second conductive block 211 corresponding to the middle position of the second bonding component 21 may be less than 0.014%. As a result, the second conductive block 211 corresponding to the middle position of the second bonding component 21 and the first conductive block 111 corresponding to the second conductive block 211 may be in the good aligned and bonded state, and thus the bonding yield of the circuit board assembly 100 may be improved more effectively.

In some embodiments, the change ratio of the overlapping state, in the first direction X, of the second conductive block 211 corresponding to the middle position of the second bonding component 21 is less than 0.005%. The definition and measurement manner of the change ratio of the overlapping state may refer to the above description, which will not be repeated here.

In this case, since the first circuit board 1 in the display module 200' provided in the present disclosure has been preshrunk, the change ratio of the overlapping state, in the first direction X, of the second conductive block 211 corresponding to the middle position of the second bonding component 21 may be less than 0.005%. As a result, the second conductive block 211 corresponding to the middle position of the second bonding component 21 and the first conductive block 111 corresponding to the second conductive block 211 may be in a better aligned and bonded state, and thus the bonding yield of the circuit board assembly 100 may be improved more effectively.

In some embodiments, providing the at least one second circuit board 2 in S30' includes S301' to S302'.

In S301', a second expansion ratio of a second circuit board 2 at a unit temperature is obtained.

In S302', a second preshrinking ratio is determined according to the second expansion ratio, so that the at least one second circuit board 2 is fabricated.

In this step, the second preshrinking ratio may be a product of the second expansion ratio of the second circuit board 2 at the unit temperature and a temperature difference, and the temperature difference is a difference between the preset temperature and the normal temperature.

A length of the second bonding component 21 after being preshrunk is equal to a length of the second bonding component 21 before being preshrunk multiplied by a difference between 1 and the second preshrinking ratio.

Based on this, each second conductive block 211 in a same second bonding component 21 overlaps with a first conductive block 111 bonded thereto, and a change ratio of an overlapping state of the second component 21 in the first direction X is less than 0.102%. The definition and measurement manner of the change ratio of the overlapping state may refer to the above description, which will not be repeated here.

In the circuit board assembly 100 described above, the change ratio of the overlapping state of the second bonding component 21 in the first direction X is less than 0.102%. That is, the second bonding component 21 in the circuit board assembly 100 provided in the present disclosure has been preshrunk. That is, both the second bonding component 21 and the first bonding component 11 in the circuit board assembly 100 provided in the present disclosure have been preshrunk. With such a design, the change ratio of the overlapping state of the second bonding component 21 in the first direction X may be less than 0.102%, so that two conductive blocks in each group of connection structures may be in a good aligned and bonded state, and thus the bonding yield of the circuit board assembly 100 may be improved.

In some embodiments, the change ratio of the overlapping state of the second bonding component 21 in the first direction X is less than 0.059%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.059%. As a result, the two conductive blocks in each group of connection structures may be in the good aligned and bonded state, and thus the bonding yield of the circuit board assembly 100 is further improved.

In some embodiments, the change ratio of the overlapping state of the second bonding component 21 in the first direction X is less than 0.039%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.039%. As a result, the two conductive blocks in each group of connection structures may be in a better aligned and bonded state, and thus the bonding yield of the circuit board assembly 100 may be further improved.

In some embodiments, the change ratio of the overlapping state of the second bonding component 21 in the first direction X is less than 0.028%. The definition and measurement manner of the change ratio of the overlapping state may refer to the above description, which will not be repeated here.

As for the circuit board assembly 100 provided in the embodiments of the present disclosure, since at least one circuit board has been preshrunk, the change ratio of the overlapping state of the second bonding component 21 in the first direction X may be less than 0.028%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.014%. The definition and measurement manner of the change ratio of the overlapping state may refer to the above description, which will not be repeated here.

In this case, since the circuit board assembly 100 provided in the present disclosure has been preshrunk, the change ratio of the overlapping state of the second bonding component 21 in the first direction X may be less than 0.014%. As a result, the two conductive blocks in each group of connection structures may be in the good aligned and bonded state, and thus the bonding yield of the circuit board assembly 100 may be improved more effectively.

In some embodiments, the change ratio of the overlapping state of the second bonding component 21 in the first direction X is less than 0.005%. The definition and measurement manner of the change ratio of the overlapping state may refer to the above description, which will not be repeated here.

In this case, since the circuit board assembly 100 provided in the present disclosure has been preshrunk, the change ratio of the overlapping state of the second bonding component 21 in the first direction X may be less than 0.005%. As a result, the two conductive blocks in each group of connection structures may be in the good aligned and bonded state, and thus the bonding yield of the circuit board assembly 100 may be improved more effectively.

In some embodiments, aligning the first bonding component 11 with the second bonding component 21 in S40' includes S401'.

In S401', the bisecting plane of the second bonding component 21 at the middle position is made coincided with the bisecting plane of the first bonding component 11.

In this way, by means of center alignment, the second conductive blocks 211 in the second bonding component 21 and the first conductive blocks 111 in the first bonding component 11 may be aligned well, and thus it helps ensure the bonding yield of the first circuit board 1 and the second circuit board 2.

In some embodiments, the first bonding component 11 further includes at least two first alignment structures 112, and the second bonding component 21 further includes at least two second alignment structures 212.

Based on this, aligning the first bonding component 11 with the second bonding component 21 in the above S40 includes S402'.

In S402', two second alignment structures 212 with the farthest distance in the first direction X in all second alignment structures 212 are aligned with two corresponding first alignment structures 112, respectively.

Since all of the plurality of second circuit boards 2 have been bonded onto the display panel 3, relative positions of bisecting planes of the plurality of second circuit boards 2 do not change. In this way, by using endmost alignment marks of the plurality of second circuit board 2 for alignment, the second conductive blocks 211 in the second bonding component 21 and the first conductive blocks 111 in the first bonding component 11 may be aligned well, and thus it helps ensure the bonding yield of the first circuit board 1 and the second circuit board 2.

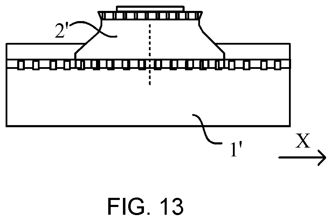

Referring to FIG. 13, FIG. 13 illustrates a structural diagram of the FPC and the main control board after being bonded in the related art. It is worth noting that, in the related art, since the expansion ratio of the FPC 2' is greater than the expansion ratio of the main control board 1', after the FPC 2' is bonded to the main control board 1', the misalignment between two conductive blocks that are bonded to each other is gradually obvious along a direction from a bisecting plane of the FPC 2' to each of two ends of the FPC 2'.

In addition, it is worth noting that, in the related art, for positions of two conductive blocks that are bonded to each other in FIG. 13, the positions are generally illustrated in a completely overlapping manner. However, it can be understood that, without the above-mentioned improvements in the present disclosure, the two conductive blocks actually have an error as shown in FIG. 13 (i.e., there is a relatively obvious misalignment between the two).

Therefore, in the circuit board assembly 100 provided in the embodiments of the present disclosure, since the second bonding component 21 has been preshrunk (for example, in a case where one first circuit board and one second circuit board are included, and the bisecting plane of the first circuit board coincides with the bisecting plane of the second circuit board, at least the second bonding component 21 of the second circuit board with a relatively large expansion ratio has been preshrunk; and as another example, in a case where one first circuit board and at least two second circuit boards are included, and the bisecting plane of at least one second circuit board does not coincide with the bisecting plane of the first circuit board, each second bonding component 21 in the at least one second circuit board and the first bonding component 11 in the first circuit board have been preshrunk). With such a design, the change ratio of the overlapping state of the second bonding component 21 in the first direction X may be less than 0.102%. As a result, the two conductive blocks in each group of connection structures may be in the good aligned and bonded state, and thus the bonding yield of the circuit board assembly 100 may be improved.

In addition, in some examples, ideally, the change ratio of the overlapping state may be equal to 0, so that the two conductive blocks bonded to each other can completely overlap with each other. Of course, in general, since the change ratio of the overlapping state is not equal to 0 due to the bonding error. For example, the change ratio of the overlapping state is in a range of 0 to 0.102%.

The above are only specific embodiments of the present disclosure, but the protection scope of the present disclosure is not limited to this. Any person skilled in the art who is familiar with the technical scope of the present disclosure, thinks of changes or replacements, should cover within the scope of protection of the present disclosure. Therefore, the protection scope of the present disclosure shall be subject to the protection scope of the claims.

## Claims

1. A circuit board assembly, comprising:

   a first circuit board including at least one first bonding component, wherein a first bonding component includes a plurality of first conductive blocks sequentially arranged at intervals in a first direction; and
   at least one second circuit board including at least one second bonding component, wherein a second bonding component includes a plurality of second conductive blocks sequentially arranged at intervals; and the plurality of second conductive blocks in the second bonding component are bonded to the plurality of first conductive blocks in the first bonding component in one-to-one correspondence;

wherein an expansion ratio of the first circuit board is less than an expansion ratio of the second circuit board; and

each second conductive block in a same second bonding component overlaps with a first conductive block bonded thereto, and a change ratio of an overlapping state of the second bonding component in the first direction is less than 0.102%.

2. The circuit board assembly according to claim 1, wherein the change ratio of the overlapping state of the second bonding component in the first direction is less than 0.059%.

3. The circuit board assembly according to claim 1, wherein the change ratio of the overlapping state of the second bonding component in the first direction is less than 0.039%.

4. The circuit board assembly according to claim 1, wherein the change ratio of the overlapping state of the second bonding component in the first direction is less than 0.028%.

5. The circuit board assembly according to any one of claims 1 to 4, wherein an overlapping width, in the first direction, of each second conductive block in the at least one second bonding component and a first conductive block bonded to the second conductive block is greater than or equal to two thirds of a width of the first conductive block.

6. The circuit board assembly according to claims 1 to 5, wherein the first circuit board includes at least two first bonding components sequentially arranged at intervals in the first direction; and at least two second bonding components are included in the at least one second circuit board; and

a change ratio of an overlapping state of each of the at least two second bonding components in the first direction is equal.

7. The circuit board assembly according to any one of claims 1 to 6, wherein the first circuit board further includes:

at least one first dummy bonding component, wherein in the first direction, the at least one first dummy bonding component and the at least one first bonding component are arranged side by side, and are alternately arranged from one side of the first circuit board to another side of the first circuit board;

a first dummy bonding component includes a plurality of first dummy conductive blocks sequentially arranged at intervals in the first direction.

8. The circuit board assembly according to any one of claims 1 to 7, wherein

a width of the first conductive block is 0.5 to 0.6 times a center-to-center distance between two adjacent first conductive blocks in the first bonding component; and

a width of the second conductive block is 0.5 to 0.6 times a center-to-center distance between two adjacent second conductive blocks in the second bonding component.

9. The circuit board assembly according to any one of claims 1 to 8, wherein a center-to-center distance between two adjacent first conductive blocks in the first bonding component is in a range of 0.3 mm to 0.4 mm, inclusive; and a center-to-center distance between two adjacent second conductive blocks in the second bonding component is in a range of 0.3 mm to 0.4 mm, inclusive.

10. The circuit board assembly according to any one of claims 1 to 9, wherein

a width of the first conductive block is in a range of 0.18 mm to 0.28 mm, inclusive; and/or

a width of the second conductive block is in a range of 0.15 mm to 0.2 mm, inclusive.

11. The circuit board assembly according to any one of claims 1 to 10, wherein an expansion ratio, at a unit temperature, of a center-to-center distance between two adjacent second conductive blocks in the second bonding component is 2 to 3 times an expansion ratio, at the unit temperature, of a center-to-center distance between two adjacent first conductive blocks in the first bonding component.

12. The circuit board assembly according to any one of claims 1 to 11, wherein the first bonding component further includes at least two first alignment structures, and the second bonding component further includes at least two second alignment structures; and a first alignment structure cooperates with a second alignment structure.

13. The circuit board assembly according to any one of claims 1 to 12, wherein

a dimension of the first circuit board in the first direction is less than or equal to 350 mm; and a dimension of the second circuit board in the first direction is less than or equal to 200 mm.

**14.** A display module, comprising:

a display panel; and
at least one circuit board assembly each according to any one of claims 1 to 13, wherein all second circuit boards of the circuit board assembly are bonded to a same side of the display panel.

**15.** The display module according to claim 14, wherein

the display panel includes at least one third bonding component, and a third bonding component includes a plurality of third conductive blocks sequentially arranged at intervals in the first direction; and
the at least one second circuit board further includes at least one fourth bonding component, a fourth bonding component includes a plurality of fourth conductive blocks sequentially arranged at intervals; and the plurality of fourth conductive blocks in the fourth bonding component are bonded to the plurality of third conductive blocks in the third bonding component in one-to-one correspondence;
wherein an overlapping width, in the first direction, of each fourth conductive block in the at least one fourth bonding component and a third conductive block bonded to the fourth conductive block is greater than or equal to two thirds of a width of the third conductive block.

**16.** A display module, comprising:

a display panel; and
a circuit board assembly located on a side of the display panel and bonded to the display panel;
wherein the circuit board assembly includes:

a first circuit board including a plurality of first bonding components, wherein a first bonding component includes a plurality of first conductive blocks sequentially arranged at intervals in a first direction; and
a plurality of second circuit boards each including at least one second bonding component, wherein a second bonding component includes a plurality of second conductive blocks sequentially arranged at intervals; and the plurality of second conductive blocks in the second bonding component are bonded to the plurality of first conductive blocks in the first bonding component in one-to-one correspondence;
wherein an expansion ratio of the first circuit board is less than an expansion ratio of the second circuit board; and
each second conductive block in a same second bonding component overlaps with a first conductive block bonded thereto; and
a change ratio of an overlapping state, in the first direction, of a second conductive block corresponding to a middle position of the second bonding component is less than 0.050%.

**17.** The display module according to claim 16, wherein the change ratio of the overlapping state, in the first direction, of the second conductive block corresponding to the middle position of the second bonding component is less than 0.039%.

**18.** The display module according to claim 16, wherein the change ratio of the overlapping state, in the first direction, of the second conductive block corresponding to the middle position of the second bonding component is less than 0.028%.

**19.** The display module according to any one of claims 16 to 18, wherein
a change ratio of an overlapping state of the second bonding component in the first direction is less than 0.102%.

**20.** The circuit board assembly according to any one of claims 16 to 18, wherein
a change ratio of an overlapping state of the second bonding component in the first direction is less than 0.059%.

**21.** The circuit board assembly according to any one of claims 16 to 18, wherein
a change ratio of an overlapping state of the second bonding component in the first direction is less than 0.039%.

**22.** The circuit board assembly according to any one of claims 16 to 18, wherein
a change ratio of an overlapping state of the second bonding component in the first direction is less than 0.028%.

**23.** The display module according to any one of claims 16 to 22, wherein the second circuit board includes a first end bonded to the first circuit board and a second end connected to the display panel; and
in a direction pointing from a bisecting plane of the first circuit board to an edge of the first circuit board, as for all second circuit boards, deviations between midpoints of first ends and midpoints of respective second ends in the first direction gradually increase.

**24.** The display module according to claim 23, wherein in a same second circuit board, a midpoint of a first end is closer to the bisecting plane of the first circuit board than a midpoint of a second end.

**25.** The display module according to any one of claims 16 to 24, wherein
as for each of all second bonding components, a change ratio of an overlapping state, in the first direction, of a second conductive block close to a bisecting plane of the second bonding component is same.

**26.** The display module according to any one of claims 16 to 25, wherein

the display panel includes at least one third bonding component, and a third bonding component includes a plurality of third conductive blocks sequentially arranged at intervals in the first direction; and
at least one second circuit board further includes at least one fourth bonding component, a fourth bonding component includes a plurality of fourth conductive blocks sequentially arranged at intervals; and the plurality of fourth conductive blocks in the fourth bonding component are bonded to the plurality of third conductive blocks in the third bonding component in one-to-one correspondence;
wherein an overlapping width, in the first direction, of each fourth conductive block in the at least one fourth bonding component and a third conductive block bonded to the fourth conductive block is greater than or equal to two thirds of a width of the third conductive block.

**27.** The display module according to any one of claims 16 to 26, wherein an overlapping width, in the first direction, of each second conductive block in at least one second bonding component and a first conductive block bonded to the second conductive block is greater than or equal to two thirds of a width of the first conductive block.

**28.** The display module according to any one of claims 16 to 27, wherein the first circuit board includes at least two first bonding components sequentially arranged at intervals in the first direction; at least one second circuit board includes at least two second bonding components; and
a change ratio of an overlapping state of each of the at least two second bonding components in the first direction is equal.

**29.** The display module according to any one of claims 16 to 28, wherein the first circuit board further includes:

at least one first dummy bonding component, wherein in the first direction, the at least one first dummy bonding component and at least one first bonding component are arranged side by side, and are alternately arranged from one side of the first circuit board to another side of the first circuit board;
wherein a first dummy bonding component includes a plurality of first dummy conductive blocks sequentially arranged at intervals in the first direction.

**30.** The display module according to any one of claims 16 to 29, wherein

a width of the first conductive block is 0.5 to 0.6 times a center-to-center distance between two adjacent first conductive blocks in the first bonding component; and
a width of the second conductive block is 0.5 to 0.6 times a center-to-center distance between two adjacent second conductive blocks in the second bonding component.

**31.** The display module according to any one of claims 16 to 30, wherein

a center-to-center distance between two adjacent first conductive blocks in the first bonding component is in a range of 0.3 mm to 0.4 mm, inclusive; and
a center-to-center distance between two adjacent second conductive blocks in the second bonding component is in a range of 0.3 mm to 0.4 mm, inclusive.

**32.** The display module according to any one of claims 16 to 31, wherein

a width of the first conductive block is in a range of 0.18 mm to 0.28 mm, inclusive; and/or,
a width of the second conductive block is in a range of 0.15 mm to 0.2 mm, inclusive.

**33.** The display module according to any one of claims 16 to 32, wherein
an expansion ratio, at a unit temperature, of a center-to-center distance between two adjacent second conductive blocks in the second bonding component is 2 to 3 times an expansion ratio, at the unit temperature, of a center-to-center distance between two adjacent first conductive blocks in the first bonding component.

**34.** The display module according to any one of claims 16 to 33, wherein
the first bonding component further includes at least two first alignment structures, and the second bonding component further includes at least two second alignment structures, wherein a first alignment structure cooperates with a second alignment structure.

35. The display module according to any one of claims 16 to 34, wherein

> a dimension of the first circuit board in the first direction is less than or equal to 350 mm; and a dimension of the second circuit board in the first direction is less than or equal to 200 mm.

36. A display apparatus, comprising:
the display module according to any one of claims 14 to 35.

37. A method for manufacturing a display module, comprising:

> obtaining a second expansion ratio of a second circuit board at a unit temperature;
> determining a second preshrinking ratio according to the second expansion ratio, so that at least one second circuit board is fabricated, wherein the at least one second circuit board includes at least one second bonding component, and a second bonding component includes a plurality of second conductive blocks sequentially arranged at intervals;
> providing a first circuit board, wherein the first circuit board includes at least one first bonding component, and a first bonding component includes a plurality of first conductive blocks sequentially arranged at intervals in a first direction;
> aligning a first bonding component with a second bonding component;
> providing a conductive adhesive between the first bonding component and the second bonding component; and
> pressing the first bonding component and the second bonding component with a preset pressure intensity after the first bonding component and the second bonding component are heated to a preset temperature, so that the plurality of second conductive blocks in the second bonding component are bonded to the plurality of first conductive blocks in the first bonding component in one-to-one correspondence, wherein each second conductive block in a same second bonding component overlaps with a first conductive block bonded thereto; and a change ratio of an overlapping state, in the first direction, of a second conductive block corresponding to a middle position of the second bonding component is less than 0.102%.

38. The manufacturing method according to claim 37, wherein providing the first circuit board, includes:

> obtaining a first expansion ratio of a first circuit board at a unit temperature; and

> determining a first preshrinking ratio according to the first expansion ratio, so that the first circuit board is fabricated;
> wherein a change ratio of an overlapping state of the second bonding component in the first direction is less than 0.039%.

39. The manufacturing method according to claim 37 or 38, wherein aligning the first bonding component with the second bonding component includes:
making a bisecting plane of the second bonding component be coincided with a bisecting plane of the first bonding component.

40. The manufacturing method according to claim 37 or 38, wherein the first bonding component further includes at least two first alignment structures, and the second bonding component further includes at least two second alignment structures; and
aligning the first bonding component with the second bonding component includes:
aligning the at least two second alignment structures in the second bonding component with the at least two first alignment structures in the first bonding component, respectively.

41. The manufacturing method according to any one of claims 37 to 40, wherein
the preset pressure intensity is in a range of 0.1 MPa to 0.4 MPa, inclusive.

42. A method for manufacturing a display module, comprising:

> obtaining a first expansion ratio of a first circuit board at a unit temperature;
> determining a first preshrinking ratio according to the first expansion ratio, so that a first circuit board is fabricated, wherein the first circuit board includes at least one first bonding component, and a first bonding component includes a plurality of first conductive blocks sequentially arranged at intervals in a first direction;
> providing at least one second circuit board, wherein the at least one second circuit board includes at least one second bonding component, and a second bonding component includes a plurality of second conductive blocks sequentially arranged at intervals;
> aligning the first bonding component with the second bonding component;
> providing a conductive adhesive between the first bonding component and the second bonding component; and
> pressing the first bonding component and the second bonding component with a preset pressure intensity after the first bonding component and the second bonding component are heated to a preset temperature, so that the plurality of second conductive blocks in the second bonding component are bonded to the plurality of first conductive blocks in the first bonding component in one-to-one correspondence;
wherein each second conductive block in a same second bonding component overlaps with a first conductive block bonded thereto; and a change ratio of an overlapping state, in the first direction, of a second conductive block corresponding to a middle position of the second bonding component is less than 0.050%.

43. The manufacturing method according to claim 42, wherein

the at least one second circuit board includes at least one fourth bonding component, and a fourth bonding component includes a plurality of fourth conductive blocks sequentially arranged at intervals;
before aligning the first bonding component with the second bonding component, the manufacturing method further comprises:

providing a display panel, wherein the display panel includes at least one third bonding component, and a third bonding component includes a plurality of third conductive blocks sequentially arranged at intervals in the first direction;
aligning the third bonding component with the fourth bonding component;
providing a conductive adhesive between the third bonding component and the fourth bonding component; and
pressing the third bonding component and the fourth bonding component with a preset pressure after the third bonding component and the fourth bonding component are heated to a preset temperature, so that the plurality of fourth conductive blocks in the fourth bonding component are bonded to the plurality of third conductive blocks in the third bonding component in one-to-one correspondence, wherein an overlapping width, in the first direction, of each fourth conductive block in the at least one fourth bonding component and a third conductive block bonded to the fourth conductive block is greater than or equal to two thirds of a width of the third conductive block.

44. The manufacturing method according to claim 43, wherein
the preset temperature is in a range of 150°C to 250°C, inclusive; and the preset pressure is in a range of 20 N to 40 N, inclusive.

45. The manufacturing method according to claim 43 or 44, wherein providing the at least one second circuit board includes:

obtaining a second expansion ratio of a second circuit board at the unit temperature; and determining a second preshrinking ratio according to the second expansion ratio, so that the at least one second circuit board is fabricated;
wherein the change ratio of the overlapping state, in the first direction, of the second conductive block corresponding to the middle position of the second bonding component is less than 0.039%.

46. The manufacturing method according to any one of claims 43 to 45, wherein
aligning the first bonding component with the second bonding component includes:
making a bisecting plane of a second bonding component at a middle position be coincided with a bisecting plane of a first bonding component.

47. The manufacturing method according to any one of claims 43 to 45, wherein the first bonding component further includes at least two first alignment structures, and the second bonding component further includes at least two second alignment structures;
aligning the first bonding component with the second bonding component includes:
aligning two second alignment structures with a farthest distance in the first direction in all second alignment structures with two corresponding first alignment structures, respectively.

48. The manufacturing method according to any one of claims 42 to 47, wherein the preset pressure intensity is in a range of 0.1 MPa to 0.4 MPa, inclusive.

100

FIG. 1

FIG. 2

FIG. 3

FIG. 4A

FIG. 4B

100

FIG. 5A

100

FIG. 5B

100

FIG. 6

200

3

O

2
100 {
1

L1

L2

X

FIG. 7A

200'

3

2
100 {
1

L1

L2

X

FIG. 7B

FIG. 7C

FIG. 8A

P

312  311  312

31

FIG. 8B

O

X

311

221

d3

a2

b2

d4

c2

FIG. 9

300(300')

200(200')

FIG. 10

Obtain a second expansion ratio of a second circuit board at a unit temperature　　S10

Determine a second preshrinking ratio according to the second expansion ratio, so that at least one second circuit board is fabricated, the at least one second circuit board including at least one second bonding component, and a second bonding component including a plurality of second conductive blocks sequentially arranged at intervals　　S20

Provide a first circuit board, the first circuit board including at least one first bonding component, and a first bonding component including a plurality of first conductive blocks sequentially arranged at intervals in a first direction　　S30

Align a first bonding component with a second bonding component　　S40

Provide a conductive adhesive between the first bonding component and the second bonding component　　S50

Press the first bonding component and the second bonding component with a preset pressure intensity after the first bonding component and the second bonding component are heated to a preset temperature, so that the plurality of second conductive blocks in the second bonding component are bonded to the plurality of first conductive blocks in the first bonding component in one-to-one correspondence, each second conductive block in a same second bonding component overlapping with a first conductive block bonded thereto; and a change ratio of an overlapping state, in the first direction, of a second conductive block corresponding to a middle position of the second bonding component being less than 0.102%　　S60

FIG. 11

| Obtain a first expansion ratio of a first circuit board at a unit temperature | S10' |

↓

| Determine a first preshrinking ratio according to the first expansion ratio, so that a first circuit board is fabricated, the first circuit board including at least one first bonding component, and a first bonding component including a plurality of first conductive blocks sequentially arranged at intervals in a first direction | S20' |

↓

| Provide at least one second circuit board, a second circuit board including at least one second bonding component, and a second bonding component including a plurality of second conductive blocks sequentially arranged at intervals | S30' |

↓

| Align a first bonding component with a second bonding component | S40' |

↓

| Provide a conductive adhesive between the first bonding component and the second bonding component | S50' |

↓

| Press the first bonding component and the second bonding component with a preset pressure intensity after the first bonding component and the second bonding component are heated to a preset temperature, so that the plurality of second conductive blocks in the second bonding component are bonded to the plurality of first conductive blocks in the first bonding component in one-to-one correspondence; each second conductive block in a same second bonding component overlapping with a first conductive block bonded thereto; and a change ratio of an overlapping state, in the first direction, of a second conductive block corresponding to a middle position of the second bonding component being less than 0.050% | S60' |

FIG. 12

FIG. 13

## INTERNATIONAL SEARCH REPORT

| International application No. |
| --- |
| **PCT/CN2021/119177** |

**A.   CLASSIFICATION OF SUBJECT MATTER**

G02F 1/1345(2006.01)i;  G09F 9/00(2006.01)i;  H05K 1/18(2006.01)i

According to International Patent Classification (IPC) or to both national classification and IPC

**B.   FIELDS SEARCHED**

Minimum documentation searched (classification system followed by classification symbols)

G02F; G09F; H05K; G02B; G09G; H01L; H01J

Documentation searched other than minimum documentation to the extent that such documents are included in the fields searched

Electronic data base consulted during the international search (name of data base and, where practicable, search terms used)

CNTXT, CNABS, WPABSC, ENTXTC, VEN: 电路板, 面板, 绑定, 导电块, 导电条, 焊盘, 膨胀率, 膨胀系数, 错位, 对位, display panel, FPC, circuit board, bonding, binding, engaging, pad?, expansion efficiencies, expansion efficiency, misalignment, alignment

**C.   DOCUMENTS CONSIDERED TO BE RELEVANT**

| Category* | Citation of document, with indication, where appropriate, of the relevant passages | Relevant to claim No. |
| --- | --- | --- |
| A | CN 101488432 A (NANJING HUAXIAN HIGH-TECH CO., LTD.) 22 July 2009 (2009-07-22)<br>    description, pages 4-5, and figures 1-5 | 1-48 |
| A | CN 113365425 A (WUHAN TIANMA MICRO-ELECTRONICS CO., LTD.) 07 September 2021 (2021-09-07)<br>    entire document | 1-48 |
| A | CN 110515492 A (WUHAN TIANMA MICRO-ELECTRONICS CO., LTD.) 29 November 2019 (2019-11-29)<br>    entire document | 1-48 |
| A | CN 112071200 A (WUHAN CHINA STAR OPTOELECTRONICS SEMICONDUCTOR DISPLAY TECHNOLOGY CO., LTD.) 11 December 2020 (2020-12-11)<br>    entire document | 1-48 |
| A | CN 113301710 A (BOE TECHNOLOGY GROUP CO., LTD. et al.) 24 August 2021 (2021-08-24)<br>    entire document | 1-48 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **19 May 2022** | **26 May 2022** |

| Name and mailing address of the ISA/CN | Authorized officer |
| --- | --- |
| **China National Intellectual Property Administration (ISA/ CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| International application No. |
| --- |
| **PCT/CN2021/119177** |

**C.    DOCUMENTS CONSIDERED TO BE RELEVANT**

| Category* | Citation of document, with indication, where appropriate, of the relevant passages | Relevant to claim No. |
| --- | --- | --- |
| A | KR 20140028461 A (LG DISPLAY CO., LTD.) 10 March 2014 (2014-03-10) entire document | 1-48 |
| A | KR 20070062107 A (SAMSUNG ELECTRONICS CO., LTD.) 15 June 2007 (2007-06-15) entire document | 1-48 |
| A | JP 2007115892 A (TOSHIBA MATSUSHITA DISPLAY TECHNOLOGY CO., LTD.) 10 May 2007 (2007-05-10) entire document | 1-48 |

Form PCT/ISA/210 (second sheet) (January 2015)

**INTERNATIONAL SEARCH REPORT**
**Information on patent family members**

International application No.

**PCT/CN2021/119177**

| Patent document cited in search report | | | Publication date (day/month/year) | Patent family member(s) | | | Publication date (day/month/year) |
|---|---|---|---|---|---|---|---|
| CN | 101488432 | A | 22 July 2009 | None | | | |
| CN | 113365425 | A | 07 September 2021 | None | | | |
| CN | 110515492 | A | 29 November 2019 | US | 10824261 | B1 | 03 November 2020 |
| CN | 112071200 | A | 11 December 2020 | None | | | |
| CN | 113301710 | A | 24 August 2021 | CN | 211090137 | U | 24 July 2020 |
| | | | | WO | 2021169882 | A1 | 02 September 2021 |
| KR | 20140028461 | A | 10 March 2014 | None | | | |
| KR | 20070062107 | A | 15 June 2007 | None | | | |
| JP | 2007115892 | A | 10 May 2007 | None | | | |

Form PCT/ISA/210 (patent family annex) (January 2015)